(19) Europäisches Patentamt / European Patent Office / Office européen des brevets

(11) **EP 2 102 886 B1**

(12) **EUROPÄISCHE PATENTSCHRIFT**

(45) Veröffentlichungstag und Bekanntmachung des Hinweises auf die Patenterteilung:
**31.08.2011 Patentblatt 2011/35**

(51) Int Cl.:
**H01J 37/26** (2006.01)

(21) Anmeldenummer: **07856102.4**

(22) Anmeldetag: **13.12.2007**

(86) Internationale Anmeldenummer:
**PCT/DE2007/002252**

(87) Internationale Veröffentlichungsnummer:
**WO 2008/074302 (26.06.2008 Gazette 2008/26)**

(54) **ELEKTRONENMIKROSKOP UND EIN VERFAHREN ZUR MESSUNG DER DEFOKUSSTREUUNG ODER DER GRENZAUFLÖSUNG**

ELECTRON MICROSCOPE AND A METHOD FOR MEASURING THE DEFOCUS SPREAD OR THE INFROMATION LIMIT

MICROSCOPE ÉLECTRONIQUE ET PROCÉDÉ DE MESURE DE LA DISPERSION DE DÉFOCALISATION OU DE LA RÉSOLUTION LIMITE

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **21.12.2006 DE 102006061978**

(43) Veröffentlichungstag der Anmeldung:
**23.09.2009 Patentblatt 2009/39**

(73) Patentinhaber: **Forschungszentrum Jülich GmbH 52425 Jülich (DE)**

(72) Erfinder:
• **THUST, Andreas**
  **50939 Köln (DE)**
• **BARTHEL, Juri**
  **41812 Erkelenz (DE)**

(56) Entgegenhaltungen:
• **SAXTON W O: "Aberration measurement and compensation for near-1 Å microscopy" PROCEEDINGS OF EMAG '95 12-15 SEPT. 1995 BIRMINGHAM, UK, 1995, Seiten 73-78, XP009099622 Electron Microscopy and Analysis 1995. Proceedings of the Institute of Physics Electron Microscopy and Analysis Group Conference IOP Publishing Bristol, UK ISBN: 0-7503-0357-3 & DATABASE INSPEC [Online] THE INSTITUTION OF ELECTRICAL ENGINEERS, STEVENAGE, GB; Database accession no. 5218343**

• **FRANK J ET AL: "NOTE ON THE EFFECT OF ILLUMINATION APERTURE AND DEFOCUS SPREAD IN BRIGHTFIELD ELECTRON MICROSCOPY" OPTIK (STUTTGART) NOV 1978, Bd. 52, Nr. 1, November 1978 (1978-11), Seiten 49-60, XP009099667 & DATABASE COMPENDEX [Online] ENGINEERING INFORMATION, INC., NEW YORK, NY, US; Database accession no. EIX79060008552**

• **ZEMLINA J ET AL: "Diffractogram tableaux by mouse click" ULTRAMICROSCOPY, AMSTERDAM, NL, Bd. 93, 1. Januar 2002 (2002-01-01), Seiten 77-82, XP007903133 ISSN: 0304-3991**

• **HANSSEN K-J ET AL: "The influence of voltage and current fluctuations and of a finite energy width of the electrons on contrast and resolution in electron microscopy" OPTIK, WISSENSCHAFTLICHE VERLAG GMBH.STUTTGART, Bd. 32, Nr. 6, 1. Januar 1971 (1971-01-01), Seiten 519-538, XP009099659 ISSN: 0030-4026**

EP 2 102 886 B1

**Beschreibung**

Die Erfindung betrifft ein Elektronenmikroskop und ein Verfahren zur Messung der Defokusstreuung oder der Grenzauflösung eines Elektronenmikroskops.

Stand der Technik

In einem Elektronenmikroskop wird das zu betrachtende Objekt mit einem Elektronenstrahl beleuchtet. Die vom Objekt reflektierte oder durch das Objekt transmittierte Strahlung oder auch vom Objekt emittierte Sekundärelektronen werden mittels elektromagnetischer Linsen zu einem vergrößerten Bild des Objektes fokussiert. Die dabei beste erreichbare Auflösung (Grenzauflösung oder Informationslimit) der Objektstruktur ist physikalisch durch eine partielle zeitliche (longitudinale) Kohärenz des Elektronenstrahls begrenzt und liegt bei modernen Mikroskopen im Bereich unterhalb eines Angströms. Aus (K.J. Hanßen, L. Trepte, Der Einfluß von Strom- und Spannungsschwankungen, sowie der Energiebreite der Strahlelektronen auf Kontrastübertragung und Auflösung des Elektronenmikroskops, Optik 32, 519 (1971)) und (K. Ishizuka, Contrast transfer of crystal images in TEM, Ultramicroscopy 5, 55-65 (1980)) ist bekannt, dass eine partielle zeitliche Kohärenz des Elektronenstrahls im Wesentlichen durch die endliche Energiebreite der Strahlelektronen, durch zeitliche Schwankungen der Beschleunigungsspannung und durch zeitliche Schwankungen des Stroms der elektromagnetischen Linsen hervorgerufen wird.

Für die Beurteilung der Verlässlichkeit von mit Elektronenmikroskopen aufgenommenen Bildern ist die Grenzauflösung von grundsätzlicher Bedeutung. Die Grenzauflösung wird durch die Defokusstreuung definiert.

Die Defokusstreuung und darüber indirekt die Grenzauflösung wird traditionell an Hand von Diffraktogrammen dünner amorpher Objekte bei zentraler Beleuchtung des Objekts ermittelt. Bei einem Diffraktogramm handelt es sich um eine optisch oder digital hergestellte Fouriertransformierte einer elektronenoptischen Abbildung. Die Intensitätsverteilung dieser Diffraktogramme hängt von den konkreten Wirkungsquerschnitten für die Beugung von Elektronen im Objekt, von der Objektdicke sowie von der Modulationsübertragungsfunktion des für die Bildaufnahme verwendeten Detektors ab. Da diese Parameter in der Praxis weitgehend unbekannt sind, können die Diffraktogramme nachteilig nicht quantitativ ausgewertet werden.

Aus (J. Frank, Nachweis von Objektbewegungen im lichtoptischen Diffraktogramm von elektronenmikroskopischen Aufnahmen, Optik 30, 171 (1969)) ist die "Young's fringe"-Methode zur Verbesserung der Sichtbarkeit von Abbildungskontrasten bekannt. Dabei werden zwei nacheinander aufgenommene Bilder eines dünnen amorphen Objekts mit einer leichten Verschiebung überlagert. Im Diffraktogramm dieser Überlagerung zeigt sich ein auffälliges Linienmuster. Die Ortsfrequenz, ab der dieses Linienmuster vom Rauschen nicht mehr zu unterscheiden ist, definiert die Grenzauflösung des Elektronenmikroskops. Sie wird an Hand qualitativer Sichtbarkeitskriterien ausgewertet.

Nachteilig ist diese Methode abhängig von einer subjektiven Bewertung durch den Beobachter. Zudem hängt die Sichtbarkeit des Linienmusters von den Verstärkungseigenschaften des Detektors sowie davon ab, ob die Intensitäten im Diffraktogramm auf einer linearen oder logarithmischen Skala dargestellt werden. Die mit dieser Methode bestimmte Grenzauflösung ist daher mit einem sehr großen und nicht eingrenzbaren Fehler behaftet.

Zudem weist die traditionelle "Young's-fringe Methode" den Nachteil auf, dass mit ihr nicht zwischen linearem und nichtlinearem Kontrast unterschieden werden kann, und nichtlineare Kontrastanteile unter bestimmten Bedingungen eine weit bessere Grenzauflösung vortäuschen können, als tatsächlich vorhanden ist. Bei der traditionellen "Young's-fringe Methode" können insbesondere bei niedrigen Beschleunigungsspannungen wegen des nichtlinearen Effekts erhebliche systematische Fehler bis zu 50% der tatsächlichen Grenzauflösung auftreten.

W.O. Saxton, "Aberration measurement and compensation for near -1 Å microscopy", Inst. Phys. Conf. Ser. No 147: Section 3, pp. 73-78 (1995), XP 9099622, offenbart im Abschnitt "4. Measuring the Illumination Coherence" u.a. ein Verfahren zur Bestimmung der Defokusstreuung aus einen Diffraktogramm in Verbindung mit einer Verkippung des Elektronenstrahls.

Aufgabe und Lösung

Es ist daher die Aufgabe der Erfindung, die Defokusstreuung sowie die Grenzauflösung von Elektronenmikroskopen in objektivierbarer Weise quantitativ bestimmbar zu machen.

Diese Aufgabe wird erfindungsgemäß gelöst durch ein Elektronenmikroskop gemäß Anspruch 1 sowie durch ein Verfahren gemäß Anspruch 6. Weitere vorteilhafte Ausgestaltungen ergeben sich jeweils aus den darauf rückbezogenen Unteransprüchen.

Gegenstand der Erfindung

Im Rahmen der Erfindung wurde ein Elektronenmikroskop entwickelt. Dieses umfasst Mittel zur Verkippung des Elektronenstrahls und Mittel zur Bestimmung der Richtungsabhängigkeit der Intensitätsverteilung von Diffraktogrammen.

Unter einem Diffraktogramm im Sinne dieser Erfindung wird die Darstellung eines mit dem Elektronenmikroskop aufgenommenen Bildes im Ortsfrequenzraum verstanden.

Erfindungsgemäß ist nun eine Auswerteeinheit vorgesehen, die aus der Richtungsabhängigkeit der Intensitätsverteilung mindestens eines mit dem Mikroskop aufgenommenen Diffraktogramms in Verbindung mit der Verkippung des Elektronenstrahls die Defokusstreuung oder die Fokusverteilung des Elektronenmikroskops zu bestimmen vermag, wobei das Oder nichtausschließlich ist.

Es wurde erkannt, dass sich die Grenzauflösung eines Elektronenmikroskops gleichberechtigt sowohl aus der Fokusverteilung als auch aus einem mathematischen Modell für diese Fokusverteilung, das die Defokusstreuung als Parameter verwendet, bestimmt werden kann.

Unter einer Bestimmung der Fokusverteilung ist jeder Erwerb von Information über die Fokusverteilung zu verstehen, insbesondere ein Erwerb von Information in einer Menge, die ausreicht, um aus der Fokusverteilung die Grenzauflösung des Elektronenmikroskops zu bestimmen. Es ist nicht erforderlich, dass die Fokusverteilung als analytische Formel vorliegt. Es reicht beispielsweise aus, wenn ihr Wert auf einer diskreten Anzahl Punkte ermittelt wird oder wenn ihr ungefährer Verlauf durch Fitten eines Funktionsansatzes mit Parametern an experimentelle Daten ermittelt wird.

Es wurde erkannt, dass bei gekippter Beleuchtung die Defokusstreuung des Elektronenmikroskops zu einer richtungsabhängigen Änderung der Intensitätsverteilung im Diffraktogramm führt. So ist beispielsweise die Einhüllende des Diffraktogramms richtungsabhängig verengt.

Sowohl die Defokusstreuung als auch die Fokusverteilung sind Größen, die ein Maß für die Grenzauflösung des Elektronenmikroskops sind und die sich aus der richtungsabhängigen Verengung der Einhüllenden des Diffraktogramms ermitteln lassen. Indem die Auswerteeinheit diese Größen einzeln oder auch in Kombination zu bestimmen vermag, vermag sie somit auch ein Maß für die Grenzauflösung des Elektronenmikroskops zu liefern.

Dabei stehen die Defokusstreuung und die Fokusverteilung in einem technischen Zusammenhang. Die Defokusstreuung ist die Breite der Fokusverteilung, wobei die Definition der Breite von der Form der Fokusverteilung abhängt und im Prinzip frei gewählt werden kann. Beispielsweise wird als Breite einer Gaußverteilung die Breite auf halber Höhe dieser Verteilung angesehen. Somit lässt sich die Defokusstreuung aus der Fokusverteilung bestimmen; es ist jedoch nicht möglich, die Fokusverteilung aus der Defokusstreuung zu bestimmen.

Die Defokusstreuung lässt sich aber auch ohne Kenntnis der Fokusverteilung direkt aus experimentellen Daten ermitteln, indem ein mathematisches Modell, in dem die Fokusverteilung beispielsweise als Gaußverteilung angenommen wird, an diese Daten gefittet wird, wobei die Defokusstreuung ein freier Parameter ist.

Ist die Verkippung des Elektronenstrahls bekannt, so ist, wenn man von Aberrationen absieht, die Defokusstreuung des Elektronenmikroskops der einzige noch unbekannte Parameter, der die richtungsabhängige Änderung der Intensitätsverteilung beeinflusst. Aus der Änderung und hier insbesondere aus einer richtungsabhängigen Verengung der Einhüllenden des Diffraktogramms können somit quantitative Rückschlüsse auf die Defokusstreuung gezogen werden. Hierzu ist es vorteilhaft, wenn das Diffraktogramm an einem amorphen Objekt aufgenommen ist, da deren konkrete Eigenschaften dann nur zu richtungsunabhängigen Änderungen in der Intensitätsverteilung führen.

Der Verwendung einer Auswerteeinheit, die die Fokusverteilung zu bestimmen vermag, liegt die Erkenntnis zu Grunde, dass jedes Elektron mit einer leicht unterschiedlichen Defokussierung zur Abbildung der Objektstruktur beiträgt. Auf diese Weise werden pro Aufnahme viele "Subbilder" mit leicht unterschiedlichem Kontrast überlagert, und als Resultat entsteht ein verschmiertes Bild des Objekts, in dem der Kontrast kleinerer Strukturdetails stärker gedämpft ist als der Kontrast größerer Strukturdetails. Die Dämpfung des Kontrastes hängt dabei von der Häufigkeit der zur Gesamtabbildung beitragenden Defokussierungen $Z$ ab. Die Häufigkeit, mit der ein Subbild einer bestimmten Defokussierung zum Resultat beiträgt, wird durch eine Fokusverteilung $f(Z)$ beschrieben. Die Dämpfung des Kontrastes wird letztendlich durch die Fouriertransformierte $F(\zeta)$ der Fokusverteilung bestimmt, wobei $\zeta = \frac{1}{2}\lambda g^2$ die zur Defokussierung konjugierte fokale Frequenz ist. Hierbei bezeichnet $\lambda$ die Elektronenwellenlänge und $g$ die zu einem Abstand d reziproke Raumfrequenz $g = 1/d$. Die Grenzauflösung eines Elektronenmikroskops wird durch den minimalen Abstand $d_{info}$ von Strukturdetails definiert, deren linearer Abbildungskontrast $F(\zeta_{info})$, mit $\zeta_{info} = \lambda/(2 d_{info}^2)$, gerade auf ein Bruchteil von $1/e^2 \approx 13,5\,\%$ des maximalen linearen Kontrastes $F(0) = 1$ gedämpft wird. Dabei wird $d_{info}$ oft als das Informationslimit des Elektronenmikroskops bezeichnet.

In einer besonders vorteilhaften Ausgestaltung der Erfindung umfasst das Elektronenmikroskop Mittel zur Bestimmung mindestens einer Aberration des Elektronenmikroskops.

Unter Aberrationen im Sinne dieser Erfindung werden insbesondere die Defokussierung, die sphärische Aberration und der Astigmatismus sowie beliebige Kombinationen daraus verstanden. Der Begriff Aberrationen umfasst jedoch alle Abbildungsfehler, die dazu führen, dass sich das von dem Elektronenmikroskop gelieferte Bild von einer idealen Abbildung der Objektstruktur unterscheidet. Beispielsweise führt eine starke sphärische Abberation zur Verschmierung lokaler Details der Objektstruktur über weite Bereiche des Bildes. Durch die Koma-Aberration können punktförmige Details der Objektstruktur im Bild elongiert erscheinen.

Unter Mitteln zur Bestimmung einer Aberration ist neben einem Messinstrument für diese Aberration oder in Kombination damit auch eine Vorrichtung zu verstehen, die die Aberration dem Elektronenmikroskop in bekannter Stärke aufzuprägen vermag. Beispielsweise kann das Elektronenmikroskop eine Einstellmöglichkeit für die Defokussierung aufweisen. Die Einstellmöglichkeit der Defokussierung ist beim Transmissionselektronenmikroskop durch die Möglichkeit zur Änderung des Objektivlinsenstroms und durch die Möglichkeit zur Verschiebung des Objektes entlang der optischen Achse realisiert.

Aberrationen sind bei elektronenmikroskopischen Aufnahmen und damit auch bei der Messung der Defokusstreuung immer vorhanden. Die Kenntnis der Aberrationen ist für die Messung der Defokusstreuung nicht zwingend notwendig. Da die Aberrationen aufgrund der partiellen räumlichen Kohärenz die Einhüllende des Diffraktogramms beeinflussen, führt ihre Berücksichtigung bei einer genaueren quantitativen Auswertung jedoch zu einer drastisch erhöhten Genauigkeit.

In einer besonders vorteilhaften Ausgestaltung der Erfindung ist das Elektronenmikroskop als Transmissionselektronenmikroskop ausgebildet. In diesem Fall hängt die Grenzauflösung des Elektronenmikroskops nur von der Defokusstreuung und der Elektronenwellenlänge ab. Die Auswerteeinheit vermag die Defokusstreuung und damit auch die Grenzauflösung des Elektronenmikroskops zu liefern.

Vorteilhaft umfasst die Auswerteeinheit einen Tiefpassfilter für das Diffraktogramm. Damit lassen sich schnell mit der Ortsfrequenz variierende Anteile aus dem Diffraktogramm entfernen, die für die Bestimmung der Defokusstreuung des Elektronenmikroskops nicht relevant sind. Es kann jede Art von Tiefpassfilter verwendet werden, beispielsweise auf der Basis von Fouriertransformationen oder auf der Basis von Wavelettransformationen.

In einer besonders vorteilhaften Ausgestaltung der Erfindung umfasst die Auswerteeinheit mindestens eine Logarithmiereinheit. Diese Einheit wandelt, beispielsweise im durch einen Tiefpassfilter abseparierten hochfrequenten Anteil eines Diffraktogramms, multiplikative Störsignale zu additiven Störsignalen, so dass diese mit dem gleichen oder einem anderen Tiefpassfilter vom Nutzsignal separiert werden können.

Die Auswerteeinheit enthält vorteilhaft ein mathematisches Modell für die Intensitätsverteilung des Diffraktogramms und hier insbesondere ein mathematisches Modell für die mit einem Tiefpass extrahierten niederfrequenten Anteile der Intensitätsverteilung des Diffraktogramms. Ein Beispiel für ein solches Modell ist im Speziellen Beschreibungsteil angegeben. Das Modell kann dann an die tatsächlich im Diffraktogramm vorliegende Intensitätsverteilung angepasst werden, wobei die zu bestimmende Defokusstreuung als Parameter verwendet werden kann. Damit wird es möglich, die Defokusstreuung auf eine Art und Weise zu bestimmen, die besonders tolerant gegen Messfehler in der Intensitätsverteilung des Diffraktogramms ist. Beispielsweise kann die Wirkung von Ausreißern in den aufgenommenen Intensitätswerten durch Anpassung des Modells mit der Methode der kleinsten Quadrate vermindert werden.

Im Rahmen der Erfindung wurde ein Verfahren zur Bestimmung der Defokusstreuung oder der Grenzauflösung eines Elektronenmikroskops entwickelt, wobei das Oder nichtausschließlich ist. Bei diesem Verfahren wird der Elektronenstrahl, der das Objekt beleuchtet, verkippt. Es wird mindestens ein Diffraktogramm an einem Objekt aufgenommen. Die Richtungsabhängigkeit der Intensitätsverteilung dieses Diffraktogramms wird bestimmt.

Erfindungsgemäß wird nun aus der Richtungsabhängigkeit dieser Intensitätsverteilung und der Verkippung des Elektronenstrahls die Defokusstreuung oder die Fokusverteilung des Elektronenmikroskops ausgewertet, wobei das Oder nichtausschließlich ist.

Es wurde erkannt, dass sich die Grenzauflösung eines Elektronenmikroskops gleichberechtigt sowohl aus der Fokusverteilung als auch aus einem mathematischen Modell für diese Fokusverteilung, das die Defokusstreuung als Parameter verwendet, bestimmt werden kann.

Unter einer Auswertung der Fokusverteilung ist jeder Erwerb von Information über die Fokusverteilung zu verstehen, insbesondere ein Erwerb von Information in einer Menge, die ausreicht, um aus der Fokusverteilung die Grenzauflösung des Elektronenmikroskops zu bestimmen. Es ist nicht erforderlich, dass die Fokusverteilung als analytische Formel vorliegt. Es reicht beispielsweise aus, wenn ihr Wert auf einer diskreten Anzahl Punkte ermittelt wird oder wenn ihr ungefährer Verlauf durch Fitten eines Funktionsansatzes mit Parametern an experimentelle Daten ermittelt wird.

Es wurde erkannt, dass bei gekippter Beleuchtung die Defokusstreuung des Elektronenmikroskops die Intensitätsverteilung im Diffraktogramm richtungsabhängig ändert. Insbesondere wird die Einhüllende des Diffraktogramms richtungsabhängig verengt.

Sowohl die Defokusstreuung als auch die Fokusverteilung sind Größen, die ein Maß für die Grenzauflösung des Elektronenmikroskops sind und die sich aus der richtungsabhängigen Verengung der Einhüllenden des Diffraktogramms ermitteln lassen. Die Auswertung dieser Größen liefert somit auch ein Maß für die Grenzauflösung des Elektronenmikroskops.

Dabei stehen die Defokusstreuung und die Fokusverteilung in einem technischen Zusammenhang. Die Defokusstreuung ist die Breite der Fokusverteilung, wobei die Definition der Breite von der Form der Fokusverteilung abhängt und im Prinzip frei gewählt werden kann. Beispielsweise wird als Breite einer Gaußverteilung die Breite auf halber Höhe dieser Verteilung angesehen. Somit lässt sich die Defokusstreuung aus der Fokusverteilung bestimmen; es ist jedoch nicht möglich, die Fokusverteilung aus der Defokusstreuung zu bestimmen.

Die Defokusstreuung lässt sich aber auch ohne Kenntnis der Fokusverteilung direkt aus experimentellen Daten ermitteln, indem ein mathematisches Modell, in dem die Fokusverteilung beispielsweise als Gaußverteilung angenommen wird, an diese Daten gefittet wird, wobei die Defokusstreuung ein freier Parameter ist.

Ist die Verkippung des Elektronenstrahls bekannt, so ist bei Vernachlässigung von Aberrationen die Defokusstreuung des Elektronenmikroskops der einzige noch unbekannte Parameter, der die Intensitätsverteilung richtungsabhängig ändert. Aus der Änderung und hier insbesondere der Verengung der Einhüllenden können somit quantitative Rückschlüsse auf die Defokusstreuung gezogen werden. Hierzu ist es vorteilhaft, wenn ein amorphes Objekt gewählt wird, da deren konkrete Eigenschaften dann nur zu richtungsunabhängigen Änderungen in der Intensitätsverteilung führen.

Der technischen Lehre, die Fokusverteilung auszuwerten, liegt die Erkenntnis zu Grunde, dass jedes Elektron mit einer leicht unterschiedlichen Defokussierung zur Abbildung der Objektstruktur beiträgt. Auf diese Weise werden pro Aufnahme viele "Subbilder" mit leicht unterschiedlichem Kontrast überlagert, und als Resultat entsteht ein verschmiertes Bild des Objekts, in dem der Kontrast kleinerer Strukturdetails stärker gedämpft ist als der Kontrast größerer Strukturdetails. Die Dämpfung des Kontrastes hängt dabei von der Häufigkeit der zur Gesamtabbildung beitragenden Defokussierungen Z ab. Die Häufigkeit, mit der ein Subbild einer bestimmten Defokussierung zum Resultat beiträgt wird durch eine Fokusverteilung $f(Z)$ beschrieben. Die Dämpfung des Kontrastes wird letztendlich durch die Fouriertransformierte $F(\xi)$ der Fokusverteilung bestimmt, wobei $\xi = \frac{1}{2}\lambda g^2$ die zur Defokussierung konjugierte fokale Frequenz ist. Hierbei bezeichnet $\lambda$ die Elektronenwellenlänge und g die zu einem Abstand $d$ reziproke Raumfrequenz $g = 1/d$. Die Grenzauflösung eines Elektronenmikroskops wird durch den minimalen Abstand $d_{info}$ von Strukturdetails definiert, deren linearer Abbildungskontrast $F(\xi_{info})$, mit $\xi_{info} = \lambda/(2d_{info}^2)$, gerade auf ein Bruchteil von $1/e^2 \approx 13,5\%$ des maximalen linearen Kontrastes $F(0) = 1$ gedämpft wird. Dabei wird $d_{info}$ oft als das Informationslimit des Elektronenmikroskops bezeichnet. Die Messung der Grenzauflösung ist somit äquivalent mit der Messung der fokalen Verteilungsfunktion $f(Z)$.

Im Gegensatz zur Auswertung der Defokusstreuung ist die Auswertung der Fokusverteilung nicht an ein angenommenes mathematisches Modell für die Fokusverteilung gebunden. Anstatt eines einzigen Parameters, der beispielsweise die Breite einer angenommenen Gaußfunktion beschreibt, kann parameterfrei eine Vielzahl von Werten, die eine beliebige Fokusverteilung beschreiben, gewonnen werden. Systematische Messfehler, die dadurch entstehen, dass die Gestalt der bei der Datenauswertung angenommenen Fokusverteilung nicht der Gestalt der bei der Messung tatsächlich vorhandenen Fokusverteilung entspricht, werden ausgeschlossen. Die zusätzliche Ermittlung der tatsächlich vorhandenen Fokusverteilung erlaubt eine nochmals genauere Bestimmung der Grenzauflösung eines Transmissionselektronenmikroskops, als es durch alleinige Auswertung der Defokusstreuung möglich ist.

Die Auswertung der Fokusverteilung verbessert gegenüber der alleinigen Auswertung der Defokusstreuung die Genauigkeit, mit der die Grenzauflösung des Elektronenmikroskops bestimmt werden kann, um so mehr, je größer die Abweichung der Fokusverteilung von der Gaußverteilung ist. Die Abweichung von der Gaußverteilung wird besonders groß in Fällen, wo das Emissionsspektrum der Elektronenquelle mittels eines Monochromators nachträglich verändert wird. Ein falsch angenommenes Modell für die Fokusverteilung kann zu systematischen Fehlern bei der Bestimmung der Grenzauflösung fuhren.

Auf der anderen Seite ist die Auswertung der Fokusverteilung ein inverses Problem, das vergleichbar ist mit dem Lösen eines linearen Gleichungssystems, wobei die Intensitätswerte aus dem experimentell bestimmten Diffraktogramm auf der rechten Seite und die hierzu beitragenden einzelnen Subbilder sowie deren Foki auf der linken Seite stehen. Sind die Intensitätswerte mit starkem Rauschen behaftet, kann dieses durch die Auswertung ähnlich verstärkt werden wie sich Rauschen auf der rechten Seite eines linearen Gleichungssystems auf dessen Lösung auswirkt. Die hierdurch entstehende Ungenauigkeit in der aus der Fokusverteilung bestimmten Grenzauflösung kann im Extremfall größer sein als die systematische Ungenauigkeit, die bei einer Auswertung der Grenzauflösung über die Defokusverteilung dadurch entsteht, dass die wahre Fokusverteilung von der Gaußverteilung abweicht.

In einer besonders vorteilhaften Ausgestaltung der Erfindung wird somit die Grenzauflösung des Elektronenmikroskops aus der Defokusstreuung oder aus der Fokusverteilung ausgewertet.

In einer besonders vorteilhaften Ausgestaltung der Erfindung wird mindestens eine Aberration des Elektronenmikroskops bestimmt. Unter Aberrationen werden insbesondere die Defokussierung, die sphärische Aberration und der Astigmatismus sowie beliebige Kombinationen daraus verstanden. Der Begriff Aberrationen umfasst jedoch alle Abbildungsfehler, die dazu führen, dass sich das von dem Elektronenmikroskop gelieferte Bild von einer idealen Abbildung der Objektstruktur unterscheidet.

Aberrationen sind bei elektronenmikroskopischen Aufnahmen und damit auch bei der Messung der Defokusstreuung immer vorhanden. Die Kenntnis der Aberrationen ist für die Messung der Defokusstreuung nicht zwingend notwendig. Da die Aberrationen aufgrund der partiellen räumlichen Kohärenz die Einhüllende des Diffraktogramms beeinflussen, führt ihre Berücksichtigung bei einer genaueren quantitativen Auswertung jedoch zu einer drastisch erhöhten Genauigkeit.

Diese Verbesserung kann auch erzielt werden, wenn an Stelle der Defokusstreuung die Fokusverteilung ausgewertet wird.

Die Bestimmung der Aberration kann passiv erfolgen, indem die Aberration gemessen wird. Diese Messung kann auch zeitgleich mit der Aufnahme des Diffraktogramms erfolgen, beispielsweise, indem ebendieses Diffraktogramm auch für die Messung der Aberration herangezogen wird. Hierfür wurde von der Anmelderin ein Verfahren entwickelt, das Gegenstand der deutschen Patentanmeldung 10 2006 038 211.0 ist. Dann ist für die Berücksichtigung der Aberration in der Messung der Defokusstreuung keine zusätzliche Datennahme erforderlich. Ebenso lässt sich im Nachhinein aus bereits vorhandenen Diffraktogrammen die Defokusstreuung rekonstruieren, die ein Elektronenmikroskop zum Zeitpunkt der Aufnahme des Diffraktogramms hatte.

Die Bestimmung der Aberration kann aktiv erfolgen, indem die Aberration dem Elektronenmikroskop in bekannter Stärke aufgeprägt wird. Beispielsweise kann eine definierte Defokussierung eingestellt werden. Ist die Defokussierung die dominierende Aberration, hat dies den Vorteil, dass das Diffraktogramm eine um seinen Ursprung im Wesentlichen isotrope Intensitätsverteilung aufweist. Für eine Auswertung des Diffraktogramms auf einer kreisförmigen Bahn um seinen Ursprung ist dann eine größere Fläche nutzbar.

Die Defokussierung lässt sich bei vielen Elektronenmikroskopen mit den gleichen Mitteln einstellen, mit denen bei normalen Abbildungen der Fokus eingestellt wird. Diese Einstellung ist in der Regel sehr genau. Höherwertige Elektronenmikroskope weisen Korrekturmechanismen für die sphärische Aberration auf, so dass diese Null sein kann. Auch der Astigmatismus lässt sich in vielen Elektronenmikroskopen durch Stigmatoren verringern oder gar eliminieren.

Die Aberration, die dem Elektronenmikroskop in bekannter Stärke aufgeprägt wird, kann ausdrücklich auch eine andere sein als diejenigen Aberrationen, die im normalen Abbildungsbetrieb des Elektronenmikroskops wirksam sind. Beispielsweise kann zur Bestimmung der Defokusstreuung eine Kombination von Defokussierung Null mit einem hohen zweizähligen Astigmatismus gewählt werden. In dieser Konfiguration sind normale Abbildungen nicht intuitiv interpretierbar, wohl aber ist die erfindungsgemäße Bestimmung der Defokusstreuung durchführbar.

Es ist auch eine Kombination aus aktiver und passiver Bestimmung der Aberration, also aus Einstellung und Messung der Aberration, möglich. Dies ist vor allem dann vorteilhaft, wenn eine im Prinzip definiert einstellbare Aberration beispielsweise einer temperaturabhängigen Drift unterliegt.

In einer besonders vorteilhaften Ausgestaltung der Erfindung wird ein Transmissionselektronenmikroskop als Mikroskop gewählt. In diesem Fall hängt die Grenzauflösung des Elektronenmikroskops nur von der Defokusstreuung und der Elektronenwellenlänge ab. Das Verfahren liefert dann neben der Defokusstreuung automatisch auch die Grenzauflösung.

Vorteilhaft wird das Diffraktogramm mit einem Tiefpassfilter gefiltert. Damit lassen sich schnell mit der Ortsfrequenz variierende Anteile aus dem Diffraktogramm entfernen, die für die Bestimmung der Defokusstreuung des Elektronenmikroskops nicht relevant sind. Die Bestimmung der Defokusstreuung wird hierdurch besonders einfach automatisierbar.

Vorteilhaft wird das Diffraktogramm logarithmiert. Beispielsweise kann der durch einen Tiefpassfilter absepararierte hochfrequente Anteil eines Diffraktogramms logarithmiert werden. Dadurch werden multiplikative Störsignale zu additiven Störsignalen, so dass diese mit dem gleichen oder einem anderen Tiefpassfilter vom Nutzsignal separiert werden können.

In einer besonders vorteilhaften Ausgestaltung der Erfindung wird das Diffraktogramm entlang einer Kreislinie um seinen Ursprung ausgewertet. Sämtliche bei einer derartigen Auswertung erfassten Änderungen in der Intensität gehen auf richtungsabhängige Beiträge zur Intensitätsverteilung zurück. Es sind genau diese Beiträge, die durch die Verkippung des Elektronenstrahls, eine eventuell vorhandene Aberration sowie die Defokusstreuung des Elektronenmikroskops bestimmt werden. Somit sind nur diese Beiträge für die Bestimmung der Defokusstreuung relevant.

Sämtliche rotationssymmetrischen additiven und multiplikativen Störsignale, die das Nutzsignal überlagern, sind auf einer Kreislinie Konstanten und beeinflussen folglich die Auswertung des Nutzsignals nicht. Betrachtet man die verengte Dämpfungsfunktion auf einer Kreislinie um das Zentrum des Diffraktogramms, so zeigen sich je zwei Maxima und zwei Minima. Die Dämpfungsfunktion ist die Einhüllende der Intensitätsverteilung, die kein durch kohärente Aberrationen bewirktes Muster enthält. Der funktionale Verlauf der Intensität zwischen Maxima und Minima entlang einer solchen Kreisbahn ist durch die Vergrößerung des Mikroskops, den Winkel der verwendeten Strahlverkippung und die Fokusverteilung im Rahmen eines Modells des Abbildungsprozesses festgelegt. Da Vergrößerung und Strahlverkippung bekannte Größen sind, ist die Fokusverteilung eindeutig definiert.

In einer weiteren vorteilhaften Ausgestaltung der Erfindung wird ein mathematisches Modell der Intensitätsverteilung des Diffraktogramms, wobei es sich insbesondere um ein Modell der niederfrequenten Anteile dieser Intensitätsverteilung handeln kann, an das aufgenommene Diffraktogramm angepasst. Ein Beispiel für ein solches Modell ist im Speziellen Beschreibungsteil angegeben. Die zu bestimmende Defokusstreuung kann dabei als Parameter verwendet werden. Damit wird es möglich, die Defokusstreuung auf eine Art und Weise zu bestimmen, die besonders tolerant gegen Messfehler in der Intensitätsverteilung des Diffraktogramms ist.

Vorteilhaft wird die Anpassung mit einem Parameteroptimierungsverfahren durchgeführt. Beispielsweise kann die Wirkung von Ausreißern in den aufgenommenen Intensitätswerten durch Anpassung des Modells mit der Methode der kleinsten Quadrate vermindert werden. Es sind aber auch beliebige andere Anpassungsverfahren wie beispielsweise das Newton-Raphson Verfahren, das Hooke-Jeeves Verfahren, genetische Algorithmen oder Verfahren zur Maximierung der Wahrscheinlichkeit verwendbar.

Vorteilhaft wird eine Folge von mindestens drei bei verschiedenen Strahlverkippungen aufgenommenen Diffraktogrammen ausgewertet, um die Genauigkeit bei der Bestimmung der Defokusstreuung zu verbessern. Hierfür kann die Folge von Diffraktogrammen insbesondere mit Strahlverkippungen bei gleichem Winkel zur optischen Achse des Elektronenmikroskops, jedoch bei gleichmäßiger Verteilung in alle azimutalen Richtungen um die optische Achse herum aufgenommen werden. Diese Ausführung der Strahlverkippungsserie als so genannte Azimutverkippungsserie erlaubt es, den Einfluss zusätzlicher, unerwünschter, richtungsabhängiger Phänomene auf das Messergebnis für die Defokusstreuung zu minimieren. Solche unerwünschten richtungsabhängigen Phänomene sind beispielsweise Objektdrift und Objektgeometrie. Da diese Phänomene ebenfalls zu richtungsabhängigen Verengungen der Einhüllenden der Intensitätsverteilung in Diffraktogrammen führen, können sie bei Auswertungen auf der Basis von nur einem einzelnem Diffraktogramm zu einer systematischen Verfälschung des Messergebnisses führen. Durch Mittelung über eine Azimutverkippungsserie kann die Verengung aufgrund der Strahlverkippung von den Verengungen aufgrund der unerwünschten Phänomene getrennt werden. Der Einfluss letzterer auf das Messergebnis wird dadurch verringert.

Diese Vorteile einer Auswertung von mindestens drei bei verschiedenen Strahlverkippungen aufgenommenen Diffraktogrammen sind auch erzielbar, wenn an Stelle der Defokusstreuung die Fokusverteilung ausgewertet wird, da auch für diese Auswertung die Richtungsabhängigkeit der Intensitätsverteilung der Diffraktogramme als Nutzsignal herangezogen wird.

In einer besonders vorteilhaften Ausgestaltung der Erfindung wird zur Auswertung der Fokusverteilung ein Gleichungssystem aufgestellt, in dem für eine Anzahl M von diskreten Punkten im Diffraktogramm jeweils der Intensitätswert des Diffraktogramms an diesem Punkt als Funktion der Werte der Fokusverteilung an einer Anzahl N von verschiedenen Sub-Foki ausgedrückt ist.

Jeder der M diskreten Punkte steuert eine Gleichung mit N Unbekannten zu diesem Gleichungssystem bei. Die M Punkte können insbesondere auf einer oder mehreren Kreisbahnen um den Ursprung des Diffraktogramms verteilt sein. Mittels eines geeigneten Anpassungs- oder Lösungsverfahrens, wie beispielsweise der Methode der kleinsten Fehlerquadrate oder dem Verfahren nach dem Prinzip der Maximierung der Entropie, können dann die Werte der Fokusverteilung an den N verschiedenen Sub-Foki als Lösungen des Gleichungssystems ermittelt werden. Die Kondition des Gleichungssystems, die ein Maß dafür ist, wie empfindlich die Lösungen auf Störungen der Intensitätswerte reagieren, lässt sich durch das Verhältnis von M zu N steuern.

Vorteilhaft wird ein lineares Gleichungssystem aufgestellt. Hierzu kann beispielsweise durch eine Filterung des Diffraktogramms mit einem Tiefpassfilter das Ringmuster aus dem Diffraktogramm entfernt werden.

Spezieller Beschreibungsteil

Nachfolgend wird der Gegenstand der Erfindung anhand eines Ausführungsbeispiels näher erläutert, ohne dass der Gegenstand der Erfindung dadurch beschränkt wird. Es ist gezeigt:

Figur 1: Einhüllende der Intensitätsverteilung in Diffraktogrammen von elektronen- mikroskopischen Aufnahmen mit konstant gekippter Beleuchtung für drei Werte der Defokusstreuung $\Delta$

Figur 2: Diffraktogramme von elektronenmikroskopischen Aufnahmen eines dünnen amorphen Kohlenstofffilms ohne und mit Strahlverkippung.

Figur 3: Diffraktogramm und dessen niederfrequente Anteile.

Figur 4: Experimentelle niederfrequente Anteile eines Diffraktogramms für zwei Bei- spielkreisbahnen.

Figur 5: Serie von Diffraktogrammen mit unterschiedlichen Strahlverkippungen.

Figur 6: Anwendung des erfindungsgemäßen Verfahrens auf zwei verschiedene Elektronenmikroskope.

Figur 7: Fokusverteilungen f (Teilbild a), die eine identische Halbwertsbreite haben, aber unterschiedliche Grenzauflösungen verursachen, sowie zugehörige Dämpfungs- funktionen F (Teilbild b).

Figur 8: Mit dem erfindungsgemäßen Verfahren bestimmte Fokusverteilung (Teilbild a) und Dämpfungsfunktion (Teilbild b) für das 300 kV Mikroskop FEI Titan 80-300.

Figur 9: Mit dem erfindungsgemäßen Verfahren bestimmte Fokusverteilung (Teilbild a) und Dämpfungsfunktion (Teilbild b) für das 200 kV Elektronenmikroskop Philips CM- 200.

Bei elektronenmikroskopischen Aufnahmen werden pro Aufnahme aufgrund der begrenzten Kohärenz des Elektronenstrahls viele "Subbilder" mit leicht unterschiedlichem Kontrast überlagert, und als Resultat entsteht ein verschmiertes Bild des Objekts, in dem der Kontrast kleinerer Strukturdetails stärker gedämpft ist als der Kontrast größerer Strukturdetails. Geht man von einer gaußförmigen Verteilung der innerhalb einer Aufnahme vorkommenden Defokuswerte aus, so wird die Dämpfung des Kontrasttransfers dann durch folgende Einhüllende beschrieben:

$$E_t(g) = \exp\left[-\left(\frac{\pi\lambda\Delta}{2}\right)^2 g^4\right] \qquad (1)$$

Dabei bezeichnet $\lambda$ die Elektronenwellenlänge und g die zu einem Abstand $d$ reziproke Ortsfrequenz $g = 1/d$, während $\Delta$ die Breite der Defokusverteilung quantifiziert. Im Folgenden wird $\Delta$ Defokusstreuung genannt. Die Grenzauflösung eines Elektronenmikroskops wird durch den minimalen Abstand $d_{info}$ von Strukturdetails definiert, deren Abbildungskontrast nach Gleichung (1) gerade ein Bruchteil von $1/e^2 \approx 13{,}5\,\%$ des maximalen Kontrastes $E_t(0) = 1$ erreicht. Dabei wird $d_{info}$ als das Informationslimit des Elektronenmikroskops bezeichnet. Das Informationslimit hängt im Falle einer gaußförmigen Defokusverteilung bei einem Transmissionselektronenmikroskop, wie es in diesem Ausführungsbeispiel verwendet wird, wie folgt von der Defokusstreuung $\Delta$ ab:

$$d_{info} = \sqrt{\pi\lambda\Delta/(2\sqrt{2})} \qquad (2)$$

Um die Grenzauflösung eines Transmissionselektronenmikroskops zu quantifizieren, werden defokusierte Diffraktogramme von Aufnahmen eines dünnen amorphen Objektes bei gekippter Beleuchtung analysiert. Durch ein dünnes amorphes Objekt werden Elektronen mit gleichen Wahrscheinlichkeiten in alle Richtungen um die Richtung des einfallenden Elektronenstrahls gestreut. Die Streuamplitude $O(g)$ des Objekts nimmt mit größeren Streuwinkeln ab. Dieses Streuverhalten gilt bei amorphen Objekten bei gekippter Beleuchtung genauso wie bei axialer Beleuchtung. In beiden Fällen ist das Betragsquadrat der Streuamplitude $|O(g)|^2$ im Diffraktogramm eine rotationssymmetrische Funktion, die mit zunehmender Ortsfrequenz $g$ abnimmt.

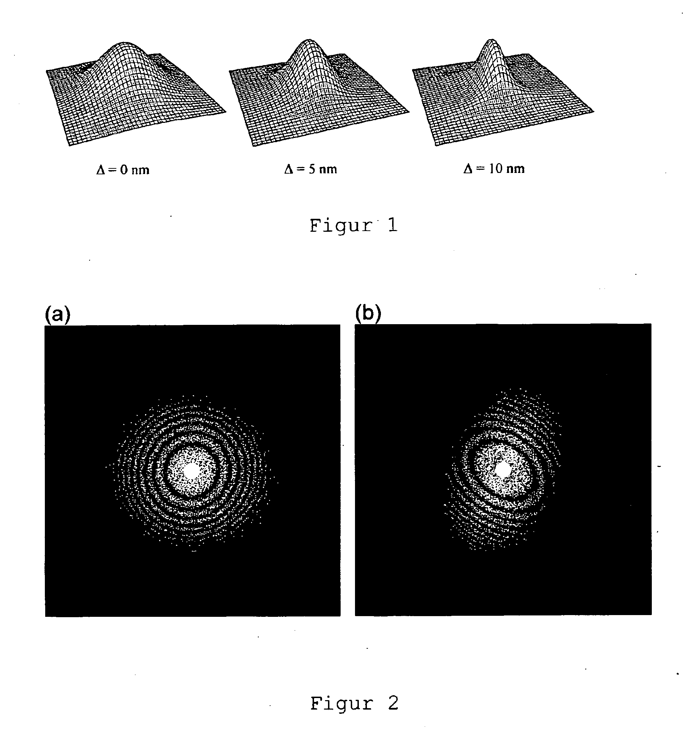

Figur 1 zeigt die Einhüllende der Intensitätsverteilung in Diffraktogrammen von elektronenmikroskopischen Aufnahmen mit konstant gekippter Beleuchtung für drei Werte der Defokusstreuung $\Delta$. Für breitere Defokusverteilungen tritt aufgrund der damit verbundenen schlechteren partiellen zeitlichen Kohärenz des Elektronenstrahls eine stärkere richtungsabhängige Verengung der Intensitätsverteilung auf. Im Kern beruht die Erfindung darauf, die richtungsabhängige Verengung als Nutzsignal aufzufassen und daraus die Defokusstreuung $\Delta$, und somit das Informationslimit (Grenzauflösung), zu bestimmen.

Für dünne amorphe Objekte zeigt ein Diffraktogramm einer defokussierten Aufnahme ein Muster aus konzentrischen Ringen, die mit zunehmender Ortsfrequenz enger werden. Die Abstände der Ringe hängen dabei von der Stärke $Z$ der Defokussierung und quadratisch von der Ortsfrequenz g ab. Im Folgenden wird dieses Ringmuster als "kohärentes Ringmuster" bezeichnet, da seine geometrische Gestalt nicht von den Kohärenzeigenschaften des Elektronenmikroskops abhängt.

Figur 2 zeigt zwei Diffraktogramme von elektronenmikroskopischen Aufnahmen eines dünnen amorphen Kohlenstofffilms. In Teilbild a ist der Strahl nicht verkippt. In Teilbild b ist der Strahl um 40 mrad verkippt.

Das kohärente Ringmuster kann neben der Defokussierung $Z$ auch von der sphärischen Aberration $C_S$ und den zwei Komponenten $A_{2x}$ und $A_{2y}$ des zweizähligen Astigmatismus abhängen. Das kohärente Ringmuster wird beschrieben durch $\sin^2[2\pi\chi(g_x, g_y)]$, wobei die Aberrationsfunktion $\chi(g_x, g_y)$ die Gesamtwirkung der einzelnen Aberrationen $Z$, $C_S$, $A_{2x}$ und $A_{2y}$ in Abhängigkeit des Beugungsvektors $\boldsymbol{g} = (g_x, g_y)$ nach folgender Gleichung beschreibt:

$$\chi(g_x, g_y) = \frac{1}{2} Z\lambda(g_x^2 + g_y^2) + \frac{1}{2} A_{2x}\lambda(g_x^2 - g_y^2) + A_{2y}\lambda g_x g_y + \frac{1}{4} C_S \lambda^3 (g_x^2 + g_y^2)^2 . \quad (3)$$

Dabei bezeichnet $\lambda$ die Elektronenwellenlänge. Zur vereinfachten Beschreibung der Messmethodik wird hier nur auf die oben genannten Aberrationen eingegangen.

Sind die Koeffizienten $Z$, $C_s$, $A_{2x}$ und $A_{2y}$ der Aberrationen in Gleichung (3) bei nicht gekippter Beleuchtung gegeben, so wird das bei starker Defokussierung $Z$ über $g$ schnell variierende, kohärente Ringmuster bei Beleuchtung mit Strahlverkippung $t$ durch $\sin^2[\chi(g+t)]$ beschrieben. Neben dem Ringmuster aufgrund der Aberrationen treten in Diffraktogrammen dünner amorpher Objekte bei gekippter Beleuchtung wie in Figur 2b mehrere multiplikative und additive Komponenten auf, die langsam über $g$ variieren. Die multiplikativen, langsam variierenden Komponenten sind das Betragsquadrat der Objektfunktion $|O(g)|^2$, sowie die Betragsquadrate der Dämpfungsfunktionen $E_t(g,t)$ und $E_s(g,t)$ aufgrund der partiellen zeitlichen und räumlichen Kohärenz des Elektronenstrahls. Letztere hängen explizit vom Beugungsvektor $g$ und von der Strahlverkippung $t$ ab. Ein additiver Beitrag der Form $\sinh^2[A(g,t)]$ beschreibt einen langsam über $g$ variierenden Untergrund, der durch unvollständige Interferenz zwischen gebeugten und nicht gebeugten Strahlen erklärt wird. Die Intensitätsverteilung $D(g)$ eines Diffraktogramms bei gekippter Beleuchtung wird durch folgende Gleichung beschrieben:

$$D(g) = |O(g)|^2 \cdot E_s^2(g,t) \cdot E_t^2(g,t) \cdot \left\{ \sin^2\left[2\pi\chi(g+t)\right] + \sinh^2\left[A(g,t)\right] \right\}. \quad (4)$$

Dabei sind die zeitliche (longitudinale) Dämpfungsfunktion $E_t(g,t)$ und die räumliche (transversale) Dämpfungsfunktion $E_s(g,t)$ gegeben durch:

$$E_t(g,t) = \exp\left\{ -\left(\frac{\pi\Delta\lambda}{2}\right)^2 \left[g^4 + 4(g \cdot t)^2\right] \right\}, \quad (5)$$

$$E_s(g,t) = \exp\left\{ -\left(\frac{\theta_0\lambda}{2}\right)^2 |\nabla\chi(g+t)|^2 \right\}. \quad (6)$$

Der Parameter $\theta_0$ bezeichnet den halben Öffnungswinkel des einfallenden Strahlenkegels der Beleuchtung. Die Dämpfung aufgrund der partiellen räumlichen Kohärenz des Elektronenstrahls hängt außerdem vom Gradienten der Aberrationsfunktion $\lambda(g+t)$ nach dem Beugungsvektor $g$ ab. Da alle in der Aberrationsfunktion berücksichtigten Aberrationen messtechnisch quantifizierbar und/oder gezielt am Elektronenmikroskop einstellbar sind, ist die Funktion $E_s(g,t)$ prinzipiell bekannt.

Im Sonderfall verschwindender Aberrationen verschwindet auch der Gradient der Aberrationsfunktion, und die Funktion $E_s(g,t)$ ist identisch gleich 1.

Die Funktion $A(g,t)$ hat nur bei gekippter Beleuchtung von Null verschiedene Werte:

$$A(g,t) = -\left(\frac{\pi\Delta\lambda}{2}\right)^2 4(g \cdot t) \cdot t^2 \quad (7)$$

Ein Tiefpassfilter wird auf jedes Diffraktogramm angewendet, so dass das Frequenzspektrum des schnell variierenden, kohärenten Ringmusters eliminiert wird, während das Frequenzspektrum der langsam variierenden Komponenten erhalten bleibt. Vom kohärenten Ringmuster nach $\sin^2[\chi(\boldsymbol{g}+\boldsymbol{t})]$ bleibt nach der Anwendung des Tiefpassfilters im allgemeinen Fall ein Mittelwert von ½ übrig. Als Resultat erhält man alle niederfrequenten Anteile $D_{\mathrm{LF}}(\boldsymbol{g},\boldsymbol{t})$ des Diffraktogramms, die ausgehend von Gleichung (4) im allgemeinen Fall durch folgende Gleichung beschrieben werden:

$$D_{\mathrm{LF}}(\boldsymbol{g},\boldsymbol{t}) = |O(g)|^2 \cdot E_{\mathrm{s}}^2(\boldsymbol{g},\boldsymbol{t}) \cdot E_{\mathrm{t}}^2(\boldsymbol{g},\boldsymbol{t}) \cdot \left\{ \frac{1}{2} + \sinh^2\left[A(\boldsymbol{g},\boldsymbol{t})\right] \right\}. \qquad (8)$$

Im Sonderfall verschwindender Aberrationen gibt es kein schnell variierendes kohärentes Ringmuster, und die Konstante 1/2 in Gleichung (8) wird zu Null. Im Sonderfall des Scherzer-Fokus, in dem das breiteste Band von Ortsfrequenzen ohne Vorzeichenwechsel übertragen wird, wird die Konstante 1/2 in Gleichung (8) zu 1.

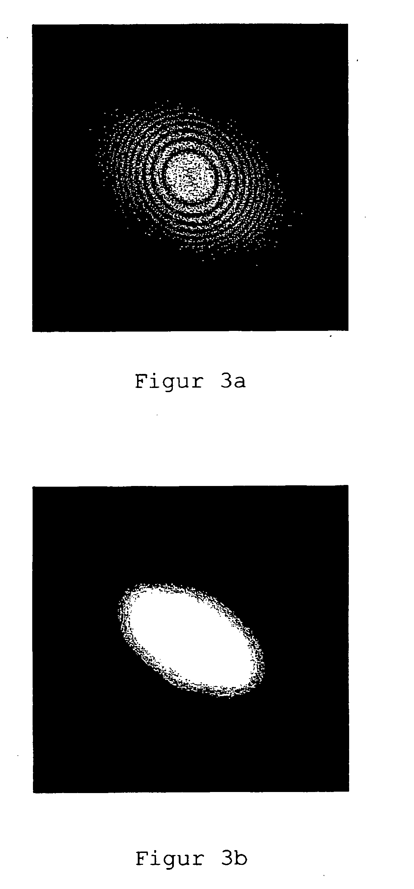

Figur 3 zeigt beispielhaft ein Diffraktogramm und dessen niederfrequente Anteile. Teilbild a zeigt das Diffraktogramm, das mit gekippter Beleuchtung an amorphem Kohlenstoff aufgenommen wurde. Teilbild b zeigt die niederfrequenten Anteile der Intensitätsverteilung, aus deren richtungsabhängiger Form sich die Defokusstreuung Δ ermitteln lässt. Die niederfrequenten Anteile zeigen auf einer Kreislinie um den Ursprung je zwei Maxima und zwei Minima. Die einzige Unbekannte zur Beschreibung des Hubs zwischen den Maxima und Minima ist die Defokusstreuung Δ.

Da die Dämpfungsfunktion $E_{\mathrm{s}}(\boldsymbol{g},\boldsymbol{t})$ für jedes Diffraktogramm aus der simultanen Aberrationsmessung bekannt ist, kann dieser Beitrag zu den niederfrequenten Anteilen der Diffraktogrammintensität mittels Division durch $E_{\mathrm{s}}$ numerisch entfernt werden. Das heißt, man erhält mit Gleichung (8)

$$D_{LF}^{*}(\boldsymbol{g},\boldsymbol{t}) = D_{\mathrm{LF}}(\boldsymbol{g},\boldsymbol{t}) / E_{\mathrm{s}}^2(\boldsymbol{g},\boldsymbol{t}). \qquad (9)$$

Bezeichnet man mit $B_0(g)$ alle rotationssymmetrischen additiven Störsignale und mit $E_0(g)$ alle rotationssymmetrischen multiplikativen Störsignale, so ergibt sich aus Gleichung (9) für die Auswertung des Nutzsignals entlang von Kreisbahnen mit dem Radius g um den Ursprung des Diffraktogramms folgendes mathematisches Modell für $D^*_{\mathrm{LF}}(\boldsymbol{g},\boldsymbol{t})$:

$$D_{\mathrm{Mod}}^{*}(g,\varphi,t,\varphi_t) = B_0(g) + E_0(g) \cdot \exp\left\{-\kappa \cdot \cos^2\left[\varphi - \varphi_t\right]\right\}$$
$$\cdot \cosh\left\{-\kappa \cdot \frac{g}{t} \cdot \cos\left[\varphi - \varphi_t\right]\right\}, \qquad (10)$$

$$\kappa = 2(\pi\Delta\lambda)^2 g^2 t^2. \qquad (11)$$

In dem Ausführungsbeispiel des erfindungsgemäßen Elektronenmikroskops enthält die Auswerteeinheit dieses mathematische Modell.

In der gewählten Darstellung der Modellfunktion $D^*_{\mathrm{Mod}}(g,\varphi, t, \varphi_t)$ in Polarkoordinaten wird der Fourierraumvektor $\boldsymbol{g}$ durch seinen Betrag $g$ und einen Azimutwinkel $\varphi$ relativ zur x-Achse des Diffraktogramms angegeben. Ebenso wird die bei der Aufnahme des auszuwertenden Diffraktograms verwendete Strahlverkippung $\boldsymbol{t}$ durch einen Betrag t und einen Azimutwinkel $\varphi_t$ charakterisiert. Der Betrag $t$ bezeichnet den Winkel der Strahlverkippung zur optischen Achse des Elektronenmikroskops, bestimmt also einen Kegelmantel, auf dem diese Verkippung liegt. Der Kippazimut $\varphi_t$ bezeichnet die Ausrichtung der Strahlverkippung in einer Ebene senkrecht zur optischen Achse relativ zu einer gegebenen Bezugsrichtung, beispielsweise der x-Achse des Diffraktogramms. Er wählt eine Verkippungsrichtung vom durch den Betrag $t$ definierten Kegelmantel aus. Bei der Auswertung jedes Diffraktogramms muss der jeweilige Kippwinkelbetrag $t$ und der Kippazimut $\varphi_t$ nach dem Modell in Gleichung (10) berücksichtigt werden.

Betrachtet man Gleichung (10), so erkennt man, dass die Terme $B_0(g)$ und $E_0(g)$ rotationssymmetrisch sind und folglich bei einer Auswertung auf Kreisbahnen als additive bzw. multiplikative Konstanten keine Motivänderungen bewirken. Der verbleibende Exponentialterm und der Kosinus-Hyperbolikus-Term variieren jeweils mit dem Kippazimut $\varphi_t$ des jeweiligen Diffraktogramms. In diesen beiden Termen sind alle eingehenden Größen $g$, $\varphi$, $t$, $\varphi_t$ und $\lambda$ bekannt. Neben den auf einer Kreisbahn konstanten Parametern $B_0(g)$ und $E_0(g)$ verbleibt einzig die Defokusstreuung $\Delta$ als anpassbarer Parameter der Modellfunktion an die mit $(\varphi-\varphi_t)$ variierenden experimentellen niederfrequenten Daten.

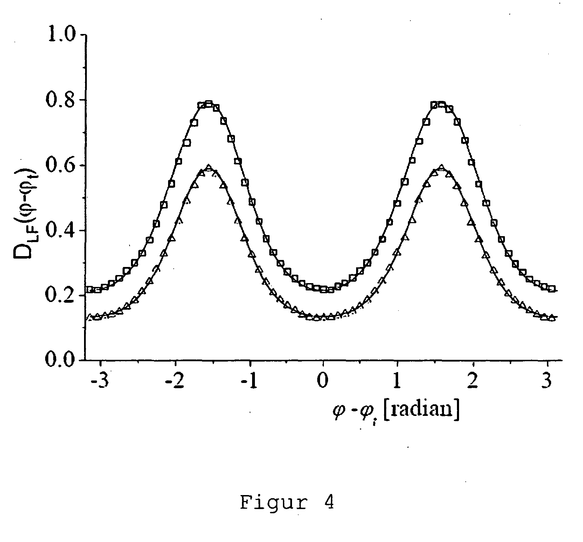

Figur 4 zeigt experimentelle niederfrequente Daten $D^*_{LF}$ für zwei Beispielkreisbahnen. Die auf einer Kreisbahn mit Radius $g$=3 nm$^{-1}$ aufgenommenen Datenpunkte sind mit Quadraten markiert. Die auf einer Kreisbahn mit Radius $g$=3,5 nm$^{-1}$aufgenommenen Datenpunkte sind mit Dreiecken markiert. Die Modellfunktion nach Gleichung (10) wurde in diesen Beispielen jeweils unter Variation der Parameter $B_0(g)$, $E_0(g)$ und $\Delta$ mit einem nicht linearen Verfahren zur Minimierung der Fehlerquadrate an die experimentellen Daten angepasst. Es kann aber auch jedes andere Anpassungsverfahren verwendet werden. Die angepasste Modellfunktion ist für beide Radien jeweils als durchgezogene Linie dargestellt.

Beispielmessung und Genauigkeitsabschätzung

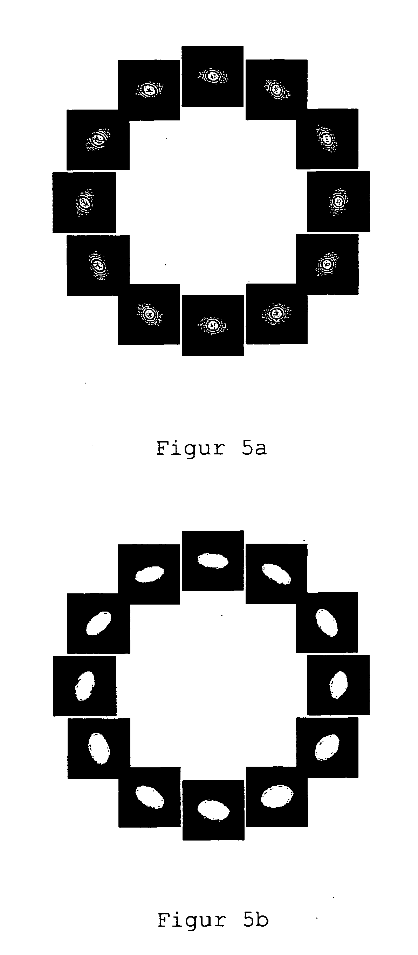

Figur 5 zeigt eine Serie von Diffraktogrammen, die mit unterschiedlichen Strahlverkippungen aufgenommen wurden. Die Strahlverkippungen wurden entsprechend einer Azimutverkippungsserie so gewählt, dass der Winkel des gekippten Elektronenstrahls zur optischen Achse des Elektronenmikroskops bei jedem Diffraktogram gleich ist, während die Azimutwinkel der Strahlverkippung in einer Ebene senkrecht zur optischen Achse äquidistant verteilt sind. Teilbild a zeigt die Diffraktogramme im Original. Teilbild b zeigt die niederfrequenten Anteile $D_{LF}$ dieser Diffraktogramme. Diese Anteile spiegeln deutlich die Abhängigkeit der Verengung der Einhüllenden von der azimutalen Richtung der Strahlverkippung wieder. Durch Mittelung der Messergebnisse der einzelnen Diffraktogramme über eine solche Azimut-Verkippungsserie verringert sich der Einfluss feststehender objektgebundener systematischer Fehler auf das Endergebnis. Insbesondere werden systematische, richtungsabhängige Fehler, die das Messergebnis aus einem Einzeldiffraktogramm verfälschen, eliminiert. Ursachen solcher systematischer Fehler können Objektdrift und Einflüsse der Objektgeometrie sein. Diese führen ebenfalls zu richtungsabhängigen Verengungen der Intensitätsverteilung im Diffraktogramm, die jedoch nicht wie das Nutzsignal konsistent der Strahlverkippung folgen. Durch Einbeziehung einer ganzen Diffraktogrammserie können die mit den bekannten Kippazimut $\varphi_t$ variierenden Signalanteile (Nutzsignal) von den konstanten Anteilen (Störsignal) absepariert werden.

Die in Figur 5 dargestellte Diffraktogrammserie kann auch zur Bestimmung von Aberrationen herangezogen werden, beispielsweise mit dem auf die Anmelderin zurückgehenden Verfahren, das Gegenstand der deutschen Patentanmeldung 10 2006 038 211.0 ist. Damit lassen sich insbesondere alle Aberrationen bestimmen, die zur Kenntnis der räumlichen Dämpfungsfunktion $E_s(g,t)$ notwendig sind.

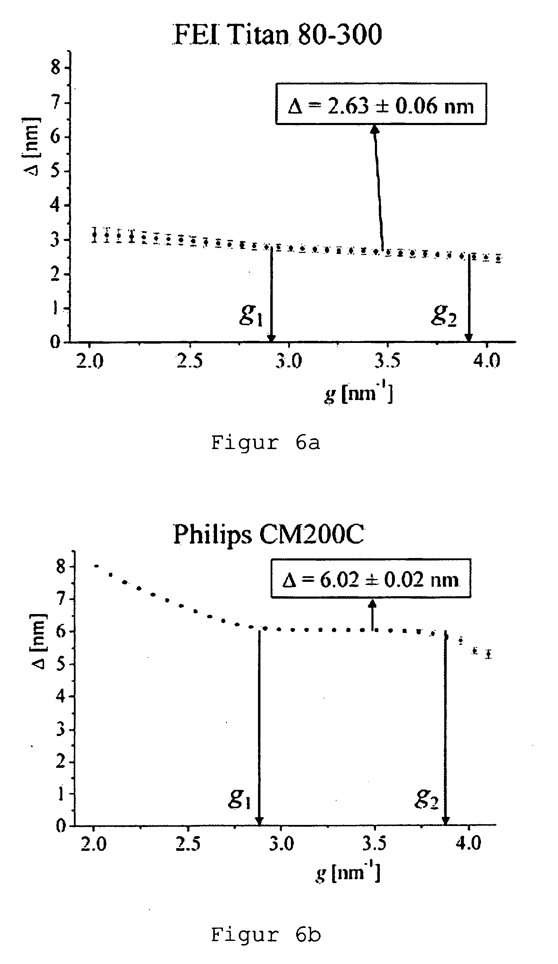

Figur 6 zeigt Resultate zweier Anwendungen des erfindungsgemäßen Verfahrens auf zwei verschiedene Transmissionselektronenmikroskope. In Teilbild a wurde das Verfahren auf das FEI Titan 80-300 und in Teilbild b auf das Philips CM200C des Ernst-Ruska-Zentrums im Forschungszentrum Jülich verwendet. Jeder Datenpunkt entspricht einer Auswertung der Gleichungen (10) und (11) auf einer Kreisbahn und nachfolgender Mittelung über alle Mitglieder einer Kippserie aus 12 Bildern.

Für das Beispiel des Mikroskops FEI Titan 80-300 ($\lambda$ = 1,969×10$^{-3}$ nm) entspricht der gemessene Wert der Defokusstreuung von $\Delta$ = 2,63 nm einer Grenzauflösung von $d_{info}$ = 0,0758 nm. Für das Elektronenmikroskop Philips CM200C ($\lambda$ = 2,508×10$^{-3}$ nm) ergibt sich nach Gleichung (2) aus der gemessenen Defokusstreuung $\Delta$ = 6,02 nm eine Grenzauflösung von $d_{info}$ = 0,129 nm.

Die in der Theorie erwartete Konstanz der Defokusstreuung $\Delta$ über die Ortsfrequenz $g$ zeigt sich im Messergebnis nur für Kreisbahnen innerhalb eines begrenztes Intervalls $g_1 < g < g_2$. In der hier beschriebenen Beispielmessung ist $g_1 \approx$ 3 nm$^{-1}$ und $g_2 \approx$ 4 nm$^{-1}$.

Die Abweichung von der theoretisch erwarteten Konstanz des Parameters $\Delta$ kann für den Bereich $g < g_1$ mit inelastischen Beiträgen zur Elektronenstreuung sowie Absorption erklärt werden, die in der verwendeten vereinfachten elastischen Theorie nicht berücksichtigt werden. Für Ortsfrequenzen unterhalb $g_1$ ist das Modell von Gleichung (4) zur Beschreibung der Diffraktogrammintensität ungültig. Im Bereich hoher Ortsfrequenzen mit $g > g_2$ tendiert die Intensität des Nutzsignals gegen Null. Dies führt kurz vor dem Verschwinden des Nutzsignals zum einen zu größeren Fehlerbalken bei der Anpassung der Modellfunktion. Zum anderen wird der Einfluss systematischer Fehler stärker.

Das letztendliche Messergebnis für die Defokusstreuung $\Delta$ wird aus dem Mittelwert aller im Intervall $g_1 < g < g_2$ durchgeführten Anpassungen der Modellfunktion nach Gleichung (10) an die experimentellen niederfrequenten Daten $D^*_{LF}$ auf Kreisbahnen bestimmt. Das Ortsfrequenzintervall für die Mittelung wird anhand der Konstanz der Messwerte für die Defokusstreuung $\Delta$ und der Größe der Fehlerbalken gewählt. Die Fehlerbalken sind in beiden Beispielen dort am kleinsten, wo die Messwerte konstant über g sind.

Die Standardabweichung vom Mittelwert der Defokusstreuung $\Delta$ im Intervall $g_1 < g < g_2$ beträgt in den in Figur 6 gezeigten Beispielmessungen 0,06 nm bzw. 0,02 nm. Dagegen wird die Genauigkeit des Verfahrens nach dem Stand der Technik aufgrund des Fehlens eines quantitativen Genauigkeitsmaßes auf etwa 0,3 nm geschätzt. Es kann deshalb angenommen werden, dass mit dem hier vorgestellten quantitativen Verfahren eine Verbesserung der Messgenauigkeit um mindestens einen Faktor 5 gegenüber dem Stand der Technik erreicht wird.

Im Folgenden wird auf die Auswertung der Grenzauflösung des Elektronenmikroskops über die Fokusverteilung eingegangen, welche im Gegensatz zur Auswertung über die Defokusstreuung nicht von der Annahme ausgeht, dass die Fokusverteilung eine Gaußverteilung ist.

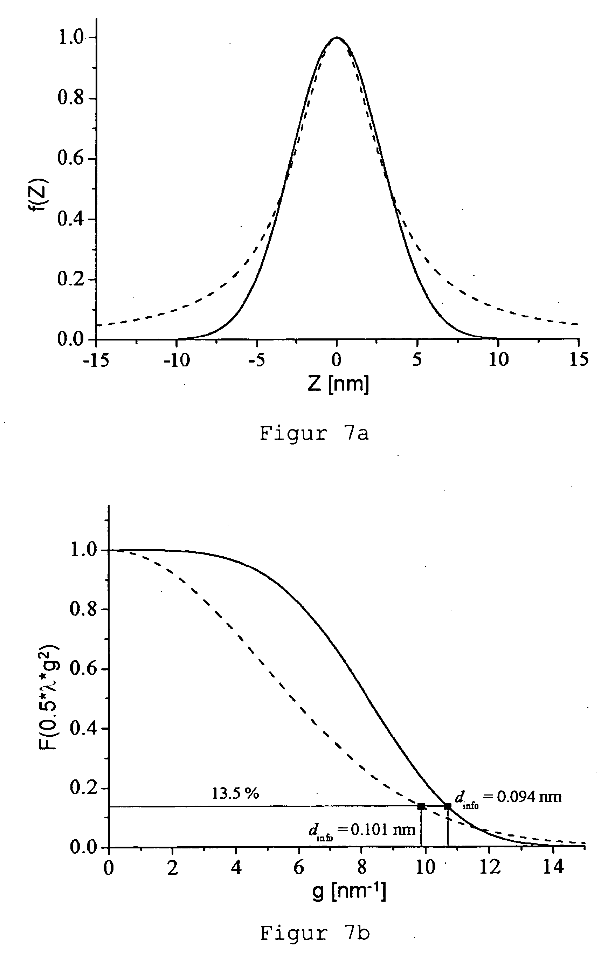

Die Abweichung von der Gaußverteilung wird besonders groß in Fällen, wo das Emissionsspektrum der Elektronenquelle mittels eines Monochromators nachträglich verändert wird. Ein falsch angenommenes Modell für die Fokusverteilung kann zu systematischen Fehlern bei der Bestimmung der Grenzauflösung führen. Figur 7a zeigt zwei Beispiele für Fokusverteilungen als Funktion des Defokus Z, die eine identische Halbwertsbreite haben, aber unterschiedliche Grenzauflösungen verursachen. Der Unterschied in den Grenzauflösungen wird aus Figur 7b ersichtlich, die die zugehörigen Dämpfungsfunktionen F als Funktion der Raumfrequenz g zeigt. In den Figuren 7a und 7b beschreibt jeweils eine gestrichelte Linie eine Lorentzverteilung, und eine durchgezogene Linie beschreibt eine Gauß-Verteilung. Die Halbwertsbreite (full width half maximum) beträgt jeweils 4 nm. Für die Lorentzverteilung ergibt sich eine Grenzauflösung $d_{info}$ von 0,101 nm, und für die Gaußverteilung ergibt sich eine Grenzauflösung $d_{info}$ von 0,094 nm. Bei der Grenzauflösung ist die Dämpfungsfunktion jeweils auf 13,5 % des maximalen linearen Kontrastes F(0)=1 abgefallen.

Für eine möglichst genaue Messung der Grenzauflösung ist deswegen die Kenntnis über den exakten Verlauf der Fokusverteilung erforderlich.

Das Auflösungsvermögen von Transmissions-Elektronenmikroskopen wird traditionell mit Diffraktogrammen dünner amorpher Objekte bei zentraler Beleuchtung des Objekts ermittelt. Dünne amorphe Objekte werden benutzt, weil diese eine gleichmäßige Elektronenstreuung in alle Richtungen aufweisen, so dass die Untersuchung des Auflösungsvermögens keine Richtung bevorzugt. Ein Diffraktogramm $D(\boldsymbol{g})$ stellt das Betragsquadrat der Fouriertransformierten eines Bildes dar. Dabei entspricht ein Punkt im Diffraktogramm einem Fourierraumvektor (Beugungsvektor) $\boldsymbol{g}$, welcher die Dimension einer Raumfrequenz hat. Aufgrund der begrenzten Auflösung des Elektronenmikroskops ist die Intensität von experimentellen Diffraktogrammen für $g = |\boldsymbol{g}| > g_{max}$ mit $g_{max} = 1/d_{info}$ nicht mehr verlässlich von Null unterscheidbar. Die Diffraktogrammintensität $D(\boldsymbol{g})$ stellt sich dar als

$$D(\boldsymbol{g}) = \left| O(\boldsymbol{g}) \right|^2 F^2(\tfrac{1}{2}\lambda \boldsymbol{g}^2)\, E_s^2(\boldsymbol{g})\, E_d^2(\boldsymbol{g}) . \qquad (12)$$

Wegen der Multiplikation der Dämpfung $F(^1/_2\lambda \boldsymbol{g}^2)$ aufgrund der partiellen zeitlichen Kohärenz des Elektronenstrahls mit (1) der Objektfunktion $O(\boldsymbol{g})$, die die Beugung von Elektronen im Objekt beschreibt, mit (2) der Dämpfung $E_s(\boldsymbol{g})$ aufgrund der partiellen räumlichen (transversalen) Kohärenz des Elektronenstrahls und mit (3) der Modulationsübertragungsfunktion $E_d(\boldsymbol{g})$ des für die Bildaufnahme verwendeten Detektors existiert kein absoluter Referenzwert, mittels dessen ein Absinken der Diffraktogrammintensität $D(\boldsymbol{g})$ auf 13,5 % in der Praxis definiert werden kann.

Das hier beschriebene Verfahren basiert auf der quantitativen Auswertung der Intensitätsverteilung von Diffraktogrammen elektronenmikroskopischer Aufnahmen unter gekippter Beleuchtung: Eine breite Fokusverteilung verursacht bei Beleuchtung mit einem gekippten Elektronenstrahl eine richtungsabhängige Verengung der Dämpfungsfunktion F und führt somit zu einer asymmetrischen Intensitätsverteilung im Diffraktogramm (siehe Figuren 2 und 5a). Für eine breitere Fokusverteilung, d. h. für schlechtere Grenzauflösung, wird eine stärkere richtungsabhängige Verengung der Dämpfungsfunktion beobachtet als mit einer engeren Verteilung. Diese von der Richtung der Strahlverkippung abhängige Verengung der Dämpfungsfunktion stellt das Nutzsignal zur Quantifizierung der Fokusverteilung dar. Zu diesem Zweck wird die Fokusverteilung an einer ausreichenden Anzahl von Stützstellen unter Berücksichtigung eines mathematischen Modells des elektronenmikroskopischen Abbildungsprozesses mittels eines geeigneten Verfahrens so bestimmt, dass die experimentellen Daten des Nutzsignals im Rahmen des Modells wiedergegeben werden.

Die Anzahl der Stützstellen richtet sich nach der Komplexität des zu erfassenden Verlaufs der Fokusverteilung und kann vom Fachmann in einer zumutbaren Anzahl Versuche entsprechend bestimmt werden. Tritt beim Hinzufügen weiterer Stützstellen keine qualitative Änderung ein, ist das ein Indikator dafür, dass die Anzahl der Stützstellen ausreichend ist.

Die Lösung ist eingeschränkt auf Fokusverteilungen $f(Z)$, die symmetrisch bezüglich ihres Schwerpunkts sind. Enthält die im Experiment wirkende Fokusverteilung einen antisymmetrischen Anteil bezüglich ihres Schwerpunktes, kann diese Verteilungsfunktion mit dem hier vorgestellten Verfahren nicht bestimmt werden. Ein in der Praxis auftretender antisymmetrische Anteil der Fokusverteilung ist jedoch typischerweise sehr klein im Verhältnis zum symmetrischen Anteil, so dass der daraus resultierende systematische Fehler in der Regel vernachlässigt werden kann. Die Annahme eines signifikanten antisymmetrischen Anteils verletzt überdies das gesamte mathematische Konzept einer durch reelle Dämpfungsenveloppen zu beschreibenden Auswirkung der partiellen zeitlichen Kohärenz, da in diesem Falle auch gravierende Änderungen des Bildkontrasts auftreten, für deren Beschreibung komplexwertige Enveloppen gebraucht würden, und somit der Begriff einer reinen Dämpfung nicht mehr zutreffend ist. Die im Folgenden gemachten Ausführungen beschränken sich auf symmetrische Fokusverteilungen und die daraus resultierenden reellwertigen Dämpfungsenveloppen, ein theoretischer Formalismus für hypothetische komplexwertige "Dämpfungsenveloppen" existiert nach dem Kenntnisstand der Erfinder noch nicht.

Um die Grenzauflösung eines Transmissionselektronenmikroskops zu quantifizieren, werden defokussierte Diffraktogramme von Aufnahmen eines dünnen amorphen Objektes bei gekippter Beleuchtung analysiert. Durch ein dünnes amorphes Objekt werden Elektronen mit gleichen Wahrscheinlichkeiten in alle Richtungen um die Richtung des einfallenden Elektronenstrahls gestreut. Die Streuamplitude $|O(\mathbf{g})|$ des Objekts nimmt mit größeren Streuwinkeln ab. Dieses Streuverhalten gilt bei amorphen Objekten bei gekippter Beleuchtung genauso wie bei axialer Beleuchtung. In beiden Fällen ist der Betrag der Streuamplitude im Diffraktogramm eine rotationssymmetrische Funktion, die mit zunehmender Raumfrequenz g abnimmt. Neben der Rotationssymmetrie des Betrags der Streufunktion ist keine weitere Kenntnis über die Streufunktion erforderlich. Der absolute Betrag und die Phase der Streufunktion werden als nicht bekannte Größen behandelt. Damit ist das Verfahren zur Messung der Grenzauflösung unabhängig von der chemischen Zusammensetzung des dünnen amorphen Objektes.

Die Fouriertransformierte einer elektronenmikroskopischen Abbildung von dünnem, amorphem Material unter verkippter Beleuchtung kann in linearer Näherung durch

$$I(\mathbf{g}) = O(\mathbf{g}) \cdot E_{\mathrm{d}}(\mathbf{g}) \cdot E_{\mathrm{s}}(\mathbf{g}, \mathbf{t}) \cdot$$
$$\sum_{Z'} f(Z') \cdot \left[ e^{-\mathrm{i}\pi\lambda Z'(g^2 + 2\mathbf{g}\mathbf{t})} e^{-\mathrm{i}\chi(\mathbf{g}+\mathbf{t})+\mathrm{i}\chi(\mathbf{t})} - e^{\mathrm{i}\pi\lambda Z'(g^2 - 2\mathbf{g}\mathbf{t})} e^{\mathrm{i}\chi(-\mathbf{g}+\mathbf{t})-\mathrm{i}\chi(\mathbf{t})} \right] \tag{13}$$

dargestellt werden. Gleichung (13) drückt die mit der gesuchten fokalen Verteilungsfunktion $f(Z)$ gewichtete Superposition von kohärenten Teilbildern als diskrete Summe über fokale Stützstellen aus. Zur grafischen Darstellung der Fouriertransformierten wird das Betragsquadrat $D(\mathbf{g}) = |I(\mathbf{g})|^2$ gebildet. Solche Darstellungen werden Diffraktogramme genannt, einige Beispiele sind in den Figuren 2 und 5a gezeigt.

In Gleichung (13) bezeichnet $\lambda$ die Elektronenwellenlänge und $\chi(\mathbf{g})$ die so genannte Aberrationsfunktion. Die Aberrationsfunktion $\chi(g_x, gy)$ beschreibt die Gesamtwirkung der vom abbildenden Gerät verursachten kohärenten optischen Abbildungsfehler (Aberrationen) auf die Elektronenwellenfunktion. Neben der Defokussierung Z werden häufig auch die sphärischen Aberration $C_\mathrm{s}$ und die zwei Komponenten $A_{2x}$, und $A_{2y}$ des zweizähligen Astigmatismus in der Aberrationsfunktion berücksichtigt. Der Beitrag der einzelnen Aberrationen $Z$, $C_\mathrm{s}$, $A_{2x}$ und $A_{2y}$ zur Aberrationsfunktion $\chi(g_x,g_y)$ in Abhängigkeit vom Beugungsvektor $\mathbf{g} = (g_x,g_y)$ wird durch Gleichung (3) beschrieben.

Für dünne amorphe Objekte zeigt ein Diffraktogramm einer defokussierten Aufnahme (d. h. $Z \neq 0$) ein Muster aus konzentrischen Ringen, die mit zunehmender Raumfrequenz enger werden. Die Abstände der Ringe hängen dabei von der Stärke Z der Defokussierung und quadratisch von der Raumfrequenz g ab, siehe Figur 2 und Gleichung (3). Das Ringmuster wird beschrieben durch $\sin^2[2\pi\chi(g_x, g_y)]$. Sind die Koeffizienten $Z$, $C_\mathrm{s}$, $A_{2x}$ und $A_{2y}$ der Aberrationen in Gleichung (13) bei nicht gekippter Beleuchtung gegeben, so wird das bei starker Defokussierung Z über g schnell variierende Ringmuster bei Beleuchtung mit Strahlverkippung $\mathbf{t}$ durch $\sin^2[\chi(\mathbf{g}+\mathbf{t})]$ beschrieben.

Neben dem Ringmuster aufgrund der Aberrationen treten in Diffraktogrammen dünner amorpher Objekte bei gekippter Beleuchtung wie in Figur 2b mehrere multiplikative und additive Komponenten auf, die im Fourierraum deutlich langsamer als das Ringmuster über die Raumfrequenz g variieren. Diese multiplikativen, langsam variierenden Komponenten sind gegeben durch die Objektfunktion $O(\mathbf{g})$, die Modulationstransferfunktion $E_\mathrm{d}(\mathbf{g})$ des Detektors, sowie durch die Dämpfungsfunktion $E_\mathrm{s}(\mathbf{g}, \mathbf{t})$ aufgrund der partiellen räumlichen Kohärenz des Elektronenstrahls.

Die multiplikative räumliche Dämpfungsfunktion $E_\mathrm{s}(\mathbf{g}, \mathbf{t})$ hängt explizit vom Beugungsvektor $\mathbf{g}$ und von der Strahlverkippung $\mathbf{t}$ ab. Sie ist gegeben durch Gleichung (6).

Der Parameter $\theta_0$ bezeichnet den halben Öffnungswinkel des einfallenden Strahlenkegels der Beleuchtung. Die Dämpfung aufgrund der partiellen räumlichen Kohärenz des Elektronenstrahls hängt außerdem vom Gradienten der Aberrationsfunktion $\chi(\mathbf{g}+\mathbf{t})$ nach dem Beugungsvektor $\mathbf{g}$ ab. Da alle in der Aberrationsfunktion berücksichtigten Aberrationen messtechnisch quantifizierbar sind, wie beispielsweise durch das Verfahren der Erfinder, das Gegenstand der deutschen Patentanmeldung 10 2006 038 211.0 ist, ist die Aberrationsfunktion $\chi$ und somit die räumliche Dämpfungsfunktion $E_\mathrm{s}(\mathbf{g},\mathbf{t})$ prinzipiell bekannt.

Die multiplikative Dämpfung aufgrund der partiellen zeitlichen Kohärenz des Elektronenstrahls entsteht durch die Überlagerung leicht defokussierter Subbilder. Diese gehen jeweils auf einzelne Elektronen zurück, die unterschiedliche Bedingungen erfahren haben, wie beispielsweise unterschiedliche Anfangsenergien beim Austritt aus der Elektronenquelle, unterschiedliche Beschleunigungsspannungen oder Schwankungen in den Linsenströmen. Sie sind mit der gesuchten Fokusverteilung $f(Z)$ wie in Gleichung (13) gewichtet.

Im Folgenden werden drei Punkte erläutert, die es erleichtern, die Fokusverteilung $f(Z)$ bestimmen zu können, trotz fehlender Kenntnis über Amplitude und Phase der Objektfunktion $O(g)$ und ohne Kenntnis der reellwertigen Modulationstransferfunktion $E_d(g)$ des Detektors. Alle weiteren Größen in Gleichung (13) sind dann bis auf die gesuchte Fokusverteilung $f(Z)$ bekannt:

1. Der Betrag $|O(g)|$ der Objektfunktion und die reellwertige Modulationstransferfunktion $E_d(g)$ des Detektors sind rotationssymmetrische Funktionen. Die Fouriertransformierte der Abbildung kann deshalb vorteilhaft entlang konzentrischer Kreisbahnen ausgewertet werden, auf denen der Betrag $|O(g)|$ der Objektfunktion und Modulationstransfer $E_d(g)$ konstante Faktoren sind.

2. Die Phase der Objektfunktion $O(g)$ beschreibt fast ausschließlich geometrische Eigenschaften des Objekts. Da das Nutzsignal, die richtungsabhängige Verengung der Intensitätsverteilung im Diffraktogramm, jedoch ein Amplitudensignal ist, das von speziellen geometrischen Eigenschaften des Objekts völlig unabhängig ist, spielen die Phasen der Fouriertransformierten für die Messung der Grenzauflösung keine Rolle.
Es kann deswegen vorteilhaft der Betrag oder eine Funktion des Betrags (z.B. das Betragsquadrat) der Fouriertransformierten der Abbildung ausgewertet werden.

3. Aufgrund der Bildung des Betrags oder des Betragsquadrates der Fouriertransformierten gehen sämtliche Phaseninformationen des Fourierraumes verloren. Diese Phaseninformation beinhaltet neben der hier nicht nützlichen geometrischen Objektinformation auch Information über einen möglicherweise in der Fokusverteilung enthaltenen antisymmetrischen Anteil. Aufgrund der Bildung des Betrags oder des Betragsquadrates geht die Information über einen möglichen antisymmetrischen Anteil an der Fokusverteilung verloren.

Für die Bestimmung von $f(Z)$ wird zunächst ein endlicher Satz von $N$ fokalen Stützstellen $\{Z_0, ... , Z_i, ... , Z_N\}$ festgelegt. Aufgrund der Annahme einer symmetrischen Fokusverteilung ist es ausreichend, sich auf den positiven Fokusbereich einzuschränken, d. h. $Z_i \geq 0$. In der Praxis lässt sich in der Regel von vornherein festlegen, welchen fokalen Bereich der Stützstellensatz mindestens abdecken muss, um das Absinken der Fokusverteilung auf Null hinreichend genau zu beschreiben. Die Anzahl $N$ und die Verteilung der $N$ Stützstellen innerhalb dieses Bereiches kann so gewählt werden, dass die Form der Fokusverteilung hinreichend genau abgetastet wird. Die Anzahl $N$ der Stützstellen wird nach oben durch die Anzahl unabhängiger experimenteller Datenpunkte auf einer Kreisbahn begrenzt. Je nach numerischer Ausführung ist es vorteilhaft, weit weniger Stützstellen als unabhängige Datenpunkte festzulegen.
Für jeden Punkt auf einer gewählten Kreisbahn mit Radius g um das Zentrum des Fourierraumes existiert nach Gleichung (2) eine eindeutige Beziehung zwischen den experimentellen Daten ($|I(g)|$ oder einer Funktion von $|I(g)|$) und der Fokusverteilung $f(Z)$. Für eine Auswahl von $M$ Punkten $g_j$ jeder Kreisbahn ergibt sich danach ein System von $M$ Gleichungen, die $N$ Unbekannte $f(Z_i)$ enthalten. Mittels eines geeigneten Anpassungs- oder Lösungsverfahrens, wie z.B. Verfahren nach dem Prinzip der Minimierung der Fehlerquadrate werden die Werte $f(Z_i)$ auf jeder Kreisbahn bestimmt. Denkbar sind hier numerische Verfahren zur unabhängigen sukzessiven Auswertung auf jeder einzelnen Kreisbahn g = const., wie soeben beschrieben, jedoch auch Verfahren zur simultanen gekoppelten Lösung aller Kreisbahnen eines einzelnen Diffraktogramms, sowie sogar zur simultanen gekoppelten Lösung aller Kreisbahnen von allen zu einer Diffraktogrammserie gehörenden Diffraktogrammen.
Die diskrete Fokusverteilung $f(Z_i)$ kann besonders vorteilhaft durch Lösen eines linearen Gleichungssystems ermittelt werden, zu dessen Aufstellung die Diffraktogrammintensität ohne das Ringmuster, das von kohärenten Aberrationen herrührt, benötigt wird. Zur Ermittlung des Nutzsignals wird das zum gegenwärtigen Zweck störende Ringmuster in zwei wesentlichen Filterschritten aus dem Diffraktogramm wie in Figur 3 entfernt, wobei nur die niederfrequenten additiven und die niederfrequenten multiplikativen Anteile eines Diffraktogramms, die das Nutzsignal bilden, erhalten bleiben:

1. Ein Tiefpassfilter wird auf das Originaldiffraktogramm angewandt, wodurch das hochfrequente Ringmuster, das von den Aberrationen herrührt, vom niederfrequenten additiven Hintergrund abgetrennt wird. Der niederfrequente Hintergrund wird als additiver Anteil des Nutzsignals an späterer Stelle weiterverarbeitet. Der hochfrequente Anteil, der das Produkt aus hochfrequentem Ringmuster mit einer multiplikativen Einhüllenden darstellt, wird im nächsten Schritt bearbeitet.

2. Vom gemäß Schritt 1 gebildeten hochfrequenten Anteil wird der Logarithmus des Betragsquadrates gebildet.

Durch die Logarithmierung werden Ringmuster und Einhüllende, die ursprünglich multiplikativ gekoppelt waren, zu additiven Komponenten. Durch einen geeigneten Tiefpassfilter, der nun auf den Logarithmus angewandt wird, können die beiden in den Originaldaten ursprünglich multiplikativ gekoppelten Größen, Ringmuster und Einhüllende, getrennt werden, wobei das schnell oszillierende Ringmuster als Störsignal in den hochfrequenten Bereich des Logarithmus zu liegen kommt, und die gewünschte Einhüllende als Nutzsignal im niederfrequenten Bereich des Logarithmus. Nach Abtrennung des hochfrequenten Störsignals (Logarithmus des Ringmusters) wird nun auf das niederfrequente Nutzsignal (Logarithmus der Einhüllenden) die Exponentialfunktion angewandt, um die Einhüllende in ursprünglicher linearer Darstellung zu wiederzugewinnen. Diese wird nun zum Ergebnis der Tiefpassfilterung aus Schritt 1 (additiver Hintergrund) addiert.

Nach Anwendung dieser beiden beschriebenen elementaren Filterschritte steht ein niederfrequentes Nutzsignal $I_{LF}(g)$ zur Verfügung, welches nicht nur frei von hochfrequentem Rauschen ist, sondern außerdem eine direkte Möglichkeit zur Bestimmung der Stützstellen der fokalen Verteilungsfunktion eröffnet. Dieses Nutzsignal entspricht dem Betrag von Gleichung (13), wobei die Aberrationsfunktion $\chi(g+t)$ - $\chi(t)$ im Bereich des entfernten hochfrequenten Ringmusters (Störsignal) durch den konstanten Wert $\pi/2$ ersetzt wird, was einem idealisierten Mikroskop mit einer über alle Raumfrequenzen aberrationsunabhängigen Kontrastübertragung entspricht. Das gefilterte Nutzsignal $I_{LF}(g)$ wird beschrieben durch

$$I_{LF}(\mathbf{g}) = \left| O(\mathbf{g}) \right| \cdot E_d(\mathbf{g}) \cdot E_s(\mathbf{g,t}) \cdot \left| \sum_{Z'} f(Z') \cdot \cos[\pi\lambda Z' g^2] \cdot e^{-2\pi i \lambda Z' \mathbf{gt}} \right| . \qquad (14)$$

Da $f(Z)$ als symmetrische Funktion angesetzt wird und $\cos[\pi\chi\lambda Z' g^2]$ eine um $Z'$=0 symmetrische Funktion ist, verschwindet der Imaginärteil der komplexwertigen Summe in Gleichung (14). Das Nutzsignal $I_{LF}(g)$ hat keine Nulldurchgänge und das Produkt $|O(g)| \cdot E_d(g) \cdot E_s(g,t)$ ist per definitionem stets positiv. Die reellwertige Summe über alle fokalen Stützstellen ist demnach ebenfalls positiv, so dass keine Betragsbildung erforderlich ist. Man erhält dann mit der Abkürzung A($g$) = $|O(g)| \cdot E_d(g)$ eine lineare Gleichung

$$I_{LF}(\mathbf{g}) = A(\mathbf{g}) \cdot E_s(\mathbf{g,t}) \cdot \sum_{Z'} f(Z') \cdot \cos[\pi\lambda Z' g^2] \cdot \cos[2\pi\lambda Z' \mathbf{gt}] . \qquad (15)$$

Auf konzentrischen Kreisbahnen um $g$=0 ist das Produkt aus Objektfunktion und Kameraübertragungsfunktion $A(g)=|O(g)| \cdot E_d(g)$ eine Konstante, und die räumliche Einhüllende $E_s(g, t)$ ist eine bekannte Funktion. Für jede nach den oben erwähnten Bedingungen gewählte Kreisbahn kann so ein System aus linearen Gleichungen aufgestellt werden, das sich mit besonders geringem Rechenaufwand nach den gesuchten Stützstellenwerten $f(Z_i)$ lösen lässt.

Durch Mittelung über eine Auswahl mehrerer Kreisbahnen können statistische Fehler in der Lösung für die $f(Z_i)$ minimiert werden. Bei der Auswahl der Kreisbahnen sollte berücksichtigt werden, dass die Dämpfung in Richtung der Strahlverkippung $t$ so stark sein sollte, dass auf dem ursprünglichen Diffraktogramm kein Ringmuster mehr erkennbar ist, während das Ringmuster in der dazu senkrechten Richtung deutlich sichtbar sein sollte. Somit existieren Kreisbahnen, die den gesamten fokalen Frequenzbereich von kleinen Werten (keine Dämpfung) bis hin zu großen Werten (Volldämpfung) abdecken. Durch Abtasten des Nutzsignals $I_{LF}(g)$ auf einer solchen Kreisbahn ist der zur Beschreibung der Dämpfungsenveloppe erforderliche fokale Frequenzbereich also vollständig erfasst. Lässt sich in einem Diffraktogramm keine solche Kreisbahn festlegen, sollte bei der Aufnahme eine stärkere Strahlverkippung verwendet werden.

Es ist weiterhin vorteilhaft den Mittelwert der Ergebnisse für die Verteilungsfunktion $f(Z_i)$ aus mehreren elektronenmikroskopischen Aufnahmen unter Beleuchtung mit unterschiedlich gekipptem Elektronenstrahl zu bestimmen. Dadurch können systematische Fehlerquellen aufgrund der Objektgeometrie und aufgrund von Probendrift gemindert werden.

Beispielmessung

Auf die Diffraktogramme einer Serie elektronenmikroskopischer Aufnahmen mit entlang eines Kreises ausgerichteten Strahlverkippungen bei gleichem Winkel der Verkippung zur optischen Achse des Mikroskops (siehe Figur 5a) wird ein angepasster Tiefpassfilter angewendet. Die resultierenden niederfrequenten Anteile der Diffraktogramme sehen qualitativ so aus wie in Figur 5b. Sie spiegeln deutlich die Abhängigkeit der Verengung der Einhüllenden von der azimutalen Richtung der Strahlverkippung wieder. Durch Mittelung der Messergebnisse der einzelnen Diffraktogramme über eine solche Azimut-Verkippungsserie verringert sich der Einfluss feststehender objekt- und objektdriftgebundener systematischer Fehler auf das Endergebnis.

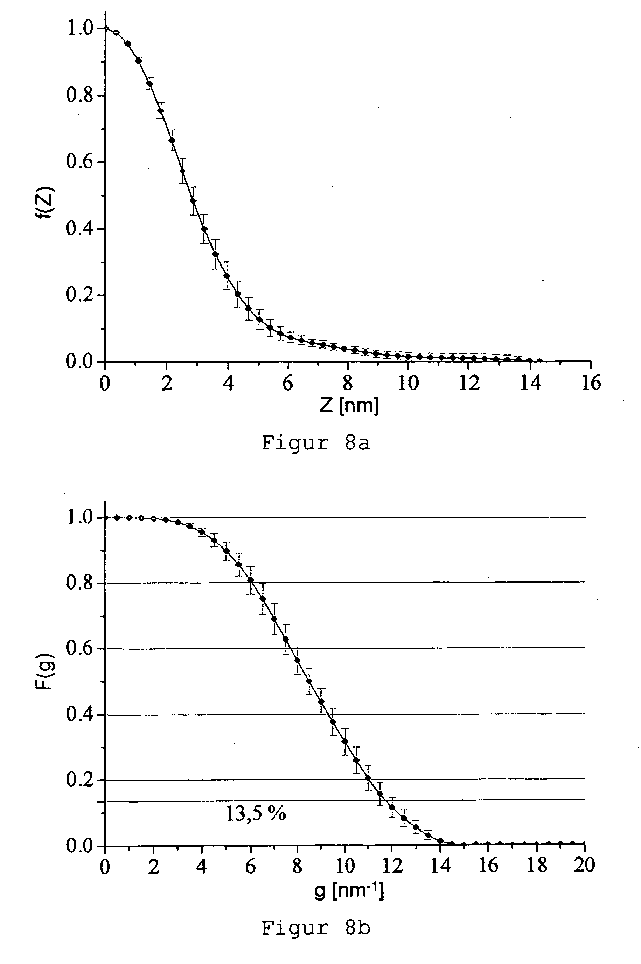

Das gesamte Verfahren wurde an zwei verschiedenen Transmissionselektronenmikroskopen angewendet. In Figur 8a sind die gemessene Fokusverteilung in Abhängigkeit der Defokussierung Z und in Figur 8b die daraus ermittelte Dämpfungsfunktion F(g) in Abhängigkeit der Raumfrequenz g für das Beispiel des 300 kV Mikroskops FEI Titan 80-300 ($\lambda = 1,969 \times 10^{-3}$ nm) bei einer Strahlverkippung von 40 mrad dargestellt. Die Dämpfungsfunktion sinkt bei einer Raumfrequenz von 1-1,8 nm$^{-1}$ auf 13,5 % ab. Das entspricht einer Grenzauflösung von $d_{info}$ = 0,085 nm.

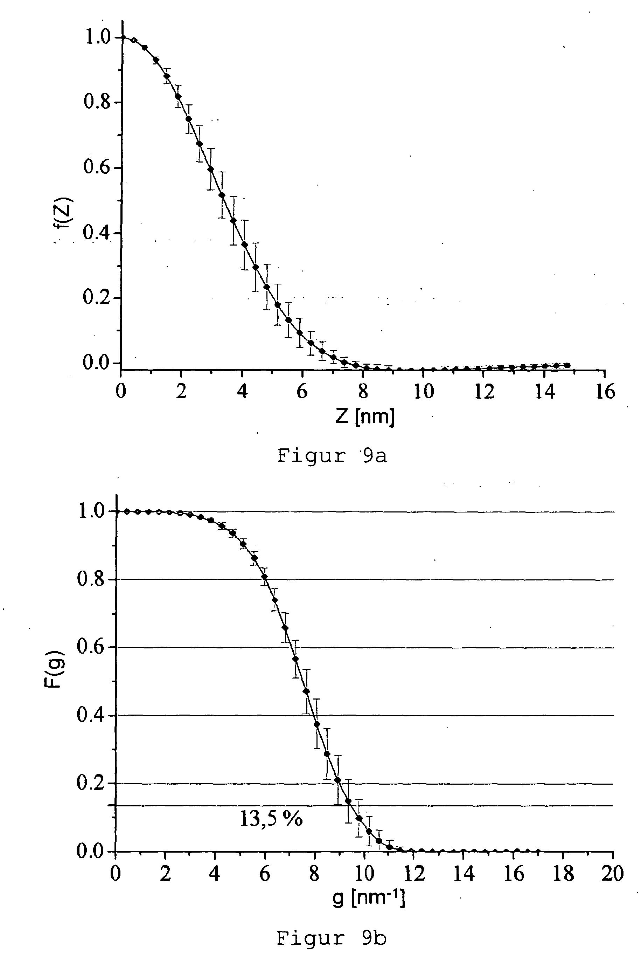

Für das 200 kV Elektronenmikroskop Philips CM-200 ($\lambda = 2,508 \times 10^{-3}$ nm) ergibt sich bei einer Strahlverkippung von 40 mrad aus der gemessenen Fokusverteilung F(Z) (Figur 9a) und der daraus bestimmten Dämpfungsfunktion f(g) (Figur 9b) eine Grenzauflösung von $d_{info}$ = 0,106 nm.

Genauigkeit des Verfahrens

Die Genauigkeit des Verfahrens wird im Folgenden auf Basis statistischer sowie auf Basis systematischer Fehler diskutiert. Ebenso spielt bei der Fehlerbetrachtung die Robustheit im Praxiseinsatz, oder genauer gesagt, das Verhalten bei schlechtem Signal-zu-Rausch Verhältnis eine Rolle.

Angaben zur statistischen Genauigkeit des Verfahrens ergeben sich aus den wechselseitigen statistischen Abweichungen der ermittelten Grenzauflösung zwischen allen ausgewerteten Kreisbahnen aller Diffraktogramme einer Strahlverkippungsserie. Statistische Fehler werden im Wesentlichen durch das in den Aufnahmen enthaltenen Rauschen verursacht.

Die Standardabweichung vom Mittelwert der Grenzauflösung beträgt in den in den Figuren 8 und 9 gezeigten Beispielmessungen 0,004 nm bzw. 0,011 nm. Dagegen wird die statistische Genauigkeit des traditionellen Verfahrens der visuellen Young's-Fringe Aufnahme aufgrund des Fehlens eines quantitativen Genauigkeitsmaßes grob auf etwa 0,03 nm geschätzt. Demnach wird mit dem hier vorgestellten quantitativen Verfahren eine Verbesserung der Messgenauigkeit auf rein statistischer Basis um mindestens einen Faktor 3 erreicht.

Zusätzlich hat sich in jüngster Zeit gezeigt, dass das traditionelle Young's-Fringe Verfahren schwere systematische Fehler aufweisen kann, die bis zu 50% der Grenzauflösung betragen können. Dies liegt u. a. an der Vernachlässigung nichtlinearer Kontrastbeiträge in den Diffraktogrammen sowie an einer Fehleinschätzung des Beitrages der nicht bekannten "runden Enveloppen" an der Kontrastdämpfung. Eigens zu diesem Zwecke durchgeführte Computersimulationen mit synthetischen nichtlinearen Bildern haben ergeben, dass das hier vorgestellte Verfahren sehr robust gegenüber störenden nichtlinearen Kontrastanteilen ist, und der entstehende systematische Fehler kaum größer als der statistische Fehler ist. Zusätzlich ist das hier vorgestellte Verfahren wegen der Auswertung auf Kreisbahnen völlig immun gegen eine Fehleinschätzung "runder Enveloppen". Was die diskutierten systematischen Fehler anbelangt, ist das hier beschriebene Verfahren dem Young's-Fringe Verfahren also klar überlegen.

Im Vergleich zu einer Auswertung lediglich der Defokusstreuung wird mit der Auswertung der Fokusverteilung bei gutem Signal-Rausch-Verhältnis eine gleichwertige statistische Genauigkeit erzielt. Die Auswertung der Fokusverteilung weist jedoch wesentlich geringere systematische Fehler auf, vor allem dann, wenn die Fokusverteilung keine gaußförmige Verteilung ist.

Die Auswertung lediglich der Defokusstreuung sollte jedoch bei schlechter Signalqualität der Eingabedaten, die sich in der Praxis nicht in jedem Falle vermeiden lässt, vorgezogen werden. Da hierbei nur ein einziger Parameter ermittelt wird, nämlich die Defokusstreuung basierend auf einem festen Gaußschen Verteilungsmodell, werden dem Verfahren von Vornherein keine Freiheitsgrade eingeräumt, bei bezüglich des Signal-zu-Rausch Verhältnisses kritischen Eingabedatensätzen Lösungen zu finden, die zu sehr dem Rauschen folgen und vom Signal zu stark abweichen. Die Robustheit dieses Verfahrens dem Rauschen gegenüber ist dann der Fähigkeit, die genaue Fokusverteilung bestimmen zu können, vorzuziehen.

Die Auswertung der Fokusverteilung bietet dann einen Vorteil gegenüber der alleinigen Auswertung der Defokusstreuung, wenn das experimentelle Rauschen so gering ist, dass ein Unterschied zwischen verschiedenen Verteilungsfunktionen sich im aufgenommenen Datensatz auch tatsächlich widerspiegelt. Verschiedene Fokusverteilungen sollten voneinander unterscheidbar sein. Da Messungen der Grenzauflösung jedoch nur selten gemacht werden müssen, ist es ein geringer Aufwand, zu diesem Zwecke eine qualitativ hochwertige Probe heranzuziehen, die ein gutes Signal-zu-Rausch Verhältnis bietet. In einem solchen Fall ermöglicht die Auswertung der Fokusverteilung eine bezüglich systematischer Fehler deutlich genauere Messung der Grenzauflösung.

Bei stark von einer Gaußfunktion abweichenden Fokusverteilungen, wie sie bei der Benutzung von Monochromatoren vorkommen können, ist die Bestimmung der Fokusverteilung unabhängig von einer Verschlechterung der Genauigkeit durch Rauschen sinnvoll.

**Patentansprüche**

1. Elektronenmikroskop, insbesondere Transmissionselektronenmikroskop, umfassend Mittel zur Verkippung des Elektronenstrahls und Mittel zur Bestimmung der Richtungsabhängigkeit der Intensitätsverteilung von Diffraktogrammen,
   **gekennzeichnet durch**
   eine Auswerteeinheit mit Mitteln zur Bestimmung der Defokusstreuung oder der Fokusverteilung des Elektronenmikroskops aus der richtungsabhängigen Verengung der Einhüllenden des kohärenten Ringmusters in mindestens einem mit dem Elektronenmikroskop aufgenommenen Diffraktogramm in Verbindung mit der Verkippung des Elektronenstrahls.

2. Elektronenmikroskop nach Anspruch 1, **gekennzeichnet durch** Mittel zur Bestimmung mindestens einer Aberration des Elektronenmikroskops, insbesondere mindestens einer Aberration aus der Gruppe Defokussierung, sphärische Aberration oder Astigmatismus.

3. Elektronenmikroskop nach einem der Ansprüche 1 bis 2, **gekennzeichnet durch** eine Auswerteeinheit umfassend einen Tiefpassfilter für das Diffraktogramm.

4. Elektronenmikroskop nach einem der Ansprüche 1 bis 3, umfassend mindestens eine Logarithmiereinheit.

5. Elektronenmikroskop nach einem der Ansprüche 1 bis 4, **gekennzeichnet durch** eine Auswerteeinheit umfassend ein mathematisches Modell für die Intensitätsverteilung des Diffraktogramms.

6. Verfahren zur Bestimmung der Defokusstreuung oder der Grenzauflösung eines Elektronenmikroskops, welches insbesondere ein Transmissionselektronenmikroskop sein kann, mit den Schritten

   - der Elektronenstrahl wird verkippt;
   - mindestens ein Diffraktogramm wird an einem, insbesondere amorphen, Objekt aufgenommen;
   - die Richtungsabhängigkeit der Intensitätsverteilung dieses Diffraktogramms wird bestimmt;
   - aus der richtungsabhängigen Verengung der Einhüllenden des kohärenten Ringmusters in dem Diffraktogramm und der Verkippung des Elektronenstrahls wird die Defokusstreuung oder die Fokusverteilung des Elektronenmikroskops bestimmt.

7. Verfahren nach Anspruch 6, **dadurch gekennzeichnet, dass** die Grenzauflösung des Elektronenmikroskops aus der Defokusstreuung oder aus der Fokusverteilung ausgewertet wird.

8. Verfahren nach einem der Ansprüche 6 bis 7, **dadurch gekennzeichnet, dass** mindestens eine Aberration des Elektronenmikroskops-insbesondere eine Aberration aus der Gruppe Defokussierung, sphärische Aberration oder Astigmatismus-bestimmt, insbesondere gemessen und/oder dem Elektronenmikroskop in bekannter Stärke aufgeprägt, wird.

9. Verfahren nach einem der Ansprüche 6 bis 8, **dadurch gekennzeichnet, dass** das Diffraktogramm mit einem Tiefpassfilter gefiltert und/oder logarithmiert und/oder entlang einer Kreislinie um seinen Ursprung ausgewertet wird.

10. Verfahren nach einem der Ansprüche 6 bis 9, **dadurch gekennzeichnet, dass** ein mathematisches Modell der Intensitätsverteilung des Diffraktogramms an das aufgenommene Diffraktogramm angepasst wird.

11. Verfahren nach Anspruch 10, **dadurch gekennzeichnet, dass** die Defokusstreuung des Elektronenmikroskops als Anpassungsparameter verwendet wird.

12. Verfahren nach einem der Ansprüche 10 bis 11, **dadurch gekennzeichnet, dass** die Anpassung mit einem Parameteroptimierungsverfahren durchgeführt wird.

13. Verfahren nach einem der Ansprüche 6 bis 12, **dadurch gekennzeichnet, dass** eine Folge von mindestens drei bei verschiedenen Strahlverkippungen aufgenommenen Diffraktogrammen ausgewertet wird.

14. Verfahren nach Anspruch 13, **dadurch gekennzeichnet, dass** die Folge mit Strahlverkippungen von konstantem Winkel zur optischen Achse und gleichmäßiger Verteilung der Kippwinkelazimute aufgenommen wird.

**15.** Verfahren nach einem der Ansprüche 6 bis 14, **dadurch gekennzeichnet, dass** zur Auswertung der Fokusverteilung ein, insbesondere lineares, Gleichungssystem mit M Gleichungen und N Unbekannten aufgestellt wird, in dem für eine Anzahl M von diskreten Punkten im Diffraktogramm jeweils der Intensitätswert des Diffraktogramms an diesem Punkt als Funktion der Werte der Fokusverteilung an einer Anzahl N von verschiedenen Sub-Foki ausgedrückt ist.

**Claims**

**1.** Electron microscope, particularly transmission electron microscope, comprising means to tilt the electron beam and means to determine the dependency of the intensity distribution of diffractograms on direction,
**characterised by**
an evaluation unit with means to determine the defocus spread or focus distribution of the electron microscope from the direction dependent contraction of the ends enclosing the coherent ring sample in at least one diffractogram picked up with an electron microscope in connection with tilting the electron beam.

**2.** Electron microscope according to claim 1, **characterised by** means to determine at least one aberration of the electron microscope, particularly at least one aberration from the defocusing group, spherical aberration or astigmatism.

**3.** Electron microscope according to one of claims 1 to 2, **characterised by** an evaluation unit comprising a deep pass filter for the diffractogram.

**4.** Electron microscope according to one of claims 1 to 3, comprising at least one logarithm unit.

**5.** Electron microscope according to one of claims 1 to 4, **characterised by** an evaluation unit comprising a mathematical model for the intensity distribution of the diffractogram.

**6.** Method for determining the defocus spread or the information limit of an electron microscope, which may be a transmission electron microscope in particular, with the steps

- the electron beam is tilted;
- at least one diffractogram is picked up on a particularly amorphous lens;
- the dependencey of the intensity distribution of the diffractogram on direction is determined;
- the defocus spread or focus distribution of the electron microscope is determined from the direction dependent contraction of the ends enclosing the coherent ring sample in the diffractogram and the tilt of the electron beam.

**7.** Method according to claim 6, **characterised in that** the information limit of the electron microscope is evaluated from the defocus spread or focus distribution.

**8.** Method according to one of claims 6 to 7, **characterised in that** at least one aberration of the electron microscope - particularly an aberration from the defocusing group, spherical aberration or astigmatism - is determined, particularly measured and/or affects the electron microscope to a known extent.

**9.** Method according to one of claims 6 to 8, **characterised in that** the diffractogram is filtered with a deep pass filter and/or its logarithm is found and/or is it evaluated along a circle around its origin.

**10.** Method according to one of claims 6 to 9, **characterised in that** a mathematical model of the intensity distribution of the diffractogram is adjusted to the diffractogram picked up.

**11.** Method according to claim 10, **characterised in that** the defocus spread of the electron microscope is used as an adjustment parameter.

**12.** Method according to one of claims 10 to 11, **characterised in that** the adjustment is made with a parameter optimisation method.

**13.** Method according to one of claims 6 to 12, **characterised in that** a series of at least three diffractograms picked up with different tilts of the beam is evaluated.

**14.** Method according to claim 13, **characterised in that** the series is picked up with the beam tilted at a constant angle to the optical axis and even distribution of the tilt angle azimuths.

**15.** Method according to one of claims 6 to 14, **characterised in that** a particularly linear equation system with M equations and N unknowns is set up to evaluate the focus distribution, in which for a number M of discrete points in the diffractogram the intensity value of the diffractogram at this point is expressed as a function of the values of focus distribution at a number N of different subfoci.

**Revendications**

**1.** Microscope électronique, comportant des moyens d'inclinaison du faisceau électronique et des moyens de détermination de l'anisotropie de la répartition d'intensité de diffractogrammes, **caractérisé par** une unité d'analyse comportant des moyens de détermination de la dispersion de défocalisation ou de la répartition focale du microscope électronique à partir du rétrécissement anisotrope de l'enveloppe du motif en anneau cohérent dans au moins un diffractogramme enregistré par le microscope électronique en relation avec l'inclinaison du faisceau électronique.

**2.** Microscope électronique selon la revendication 1, **caractérisé par** des moyens de détermination d'au moins une aberration du microscope électronique, en particulier d'au moins une aberration du groupe comprenant la défocalisation, l'aberration sphérique ou l'astigmatisme.

**3.** Microscope électronique selon l'une des revendications 1 ou 2, **caractérisé par** une unité d'analyse comprenant un filtre passe-bas pour le diffractogramme.

**4.** Microscope électronique selon l'une des revendications 1 à 3, comprenant au moins une unité de calcul logarithmique.

**5.** Microscope électronique selon l'une des revendications 1 à 4, **caractérisé par** une unité d'analyse comprenant un modèle mathématique pour la répartition d'intensité du diffractogramme.

**6.** Procédé de détermination de la dispersion de défocalisation d'un microscope électronique, comportant les étapes suivantes:

- le faisceau électronique est incliné;
- au moins un diffractogramme est enregistré sur un objet ;
- l'anisotropie de la répartition d'intensité dudit diffractogramme est déterminée ;
- la dispersion de défocalisation ou la répartition focale du microscope électronique est évaluée à partir du rétrécissement anisotrope de l'enveloppe du motif en anneau cohérent dans le diffractogramme et de l'inclinaison du faisceau électronique.

**7.** Procédé selon la revendication 6, **caractérisé en ce que** la résolution limite du microscope électronique est évaluée à partir de la dispersion de défocalisation ou de la répartition focale.

**8.** Procédé selon l'une des revendications 6 ou 7, **caractérisé en ce qu'**au moins une aberration du microscope électronique, en particulier une aberration du groupe comprenant la défocalisation, l'aberration sphérique ou l'astigmatisme, est déterminée, notamment mesurée et/ou réglée sur le microscope électronique suivant une intensité connue.

**9.** Procédé selon l'une des revendications 6 à 8, **caractérisé en ce que** le diffractogramme est filtré par un filtre passe-bas et/ou soumis à un calcul logarithmique et/ou analysé sur une circonférence autour de son origine.

**10.** Procédé selon l'une des revendications 6 à 9, **caractérisé en ce qu'**un modèle mathématique de répartition d'intensité du diffractogramme est adapté au diffractogramme enregistré.

**11.** Procédé selon la revendication 10, **caractérisé en ce que** la dispersion de défocalisation du microscope électronique est exploitée comme paramètre d'adaptation.

**12.** Procédé selon l'une des revendications 10 à 11, **caractérisé en ce que** l'adaptation est effectuée au moyen d'un procédé d'optimisation de paramètres.

**13.** Procédé selon l'une des revendications 6 à 12, **caractérisé en ce qu'**une série d'au moins trois diffractogrammes enregistrés sous différentes inclinaisons de faisceau est évaluée.

**14.** Procédé selon la revendication 13, **caractérisé en ce que** la série est enregistrée avec des inclinaisons de faisceau suivant un angle constant par rapport à l'axe optique et répartition homogène des azimuts d'angles d'inclinaison.

**15.** Procédé selon l'une des revendications 6 à 14, **caractérisé en ce qu'**un système d'équation notamment linéaire à M équations et N inconnues est élaboré pour l'analyse de la répartition focale, où, pour un nombre M de points discrets dans le diffractogramme, la valeur d'intensité du diffractogramme est exprimée sur chaque point comme fonction des valeurs de répartition focale sur un nombre N de sous-foyers différents.

Δ = 0 nm          Δ = 5 nm          Δ = 10 nm

Figur 1

(a)                              (b)

Figur 2

Figur 3a

Figur 3b

Figur 4

Figur 5a

Figur 5b

## FEI Titan 80-300

Figur 6a

## Philips CM200C

Figur 6b

Figur 7a

Figur 7b

Figur 8a

13,5 %

Figur 8b

Figur 9a

Figur 9b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006038211

**In der Beschreibung aufgeführte Nicht-Patentliteratur**

- **K.J. Hanßen ; L. Trepte.** Der Einfluß von Strom- und Spannungsschwankungen, sowie der Energiebreite der Strahlelektronen auf Kontrastübertragung und Auflösung des Elektronenmikroskops. *Optik,* 1971, vol. 32, 519
- **K. Ishizuka.** Contrast transfer of crystal images in TEM. *Ultramicroscopy,* 1980, vol. 5, 55-65
- **J. Frank.** Nachweis von Objektbewegungen im lichtoptischen Diffraktogramm von elektronenmikroskopischen Aufnahmen. *Optik,* 1969, vol. 30, 171
- **W.O. Saxton.** Aberration measurement and compensation for near -1 Å microscopy. *Inst. Phys. Conf. Ser. No 147,* 1995, 73-78